# EUROPÄISCHE PATENTSCHRIFT

(11) **EP 2 789 578 B1**
(45) Veröffentlichungstag und Bekanntmachung des Hinweises auf die Patenterteilung: **20.06.2018**
(21) Anmeldenummer: 14160818.2
(22) Anmeldetag: 20.03.2014
(51) Int. Cl.: B81B 7/00

(54) **Bauelement mit federnden Elementen und Verfahren zur Herstellung des Bauelements**
Component with spring elements and a method of manufacturing the component
Dispositif avec des éléments formant ressort et procédé de fabrication du dispositif

(30) Priorität: 12.04.2013 DE 102013206524
(43) Veröffentlichungstag der Anmeldung: 15.10.2014
(73) Patentinhaber: ROBERT BOSCH GMBH, 70442 Stuttgart (DE)
(72) Erfinder: Hoefer, Holger, 72820 Sonnenbuehl (DE); Solf, Christian, 76287 Rheinstetten (DE); Ehrenpfordt, Ricardo, 70825 Korntal-Muenchingen (DE); Pantel, Daniel, 71254 Ditzingen (DE); Ante, Frederik, 70197 Stuttgart (DE); Offterdinger, Klaus, 70619 Stuttgart (DE); Grabmaier, Florian, 72076 Tuebingen (DE)

(56) Entgegenhaltungen:
- DE-A1-102010 030 960
- US-A1- 2004 022 042

## Beschreibung

### Stand der Technik

Die vorliegende Erfindung bezieht sich auf ein Bauelement, auf einen Nutzen aus entsprechenden Bauelementen sowie auf ein Verfahren zum Herstellen eines Bauelements.

Bauelemente können schwingungsempfindliche Komponenten umfassen. Durch eine federnde Lagerung können Schwingungen der Komponenten verringert werden.

Die DE 10 2006 026 878 A1 beschreibt ein Premold-Gehäuse mit integrierter Schwingungsisolierung.

### Offenbarung der Erfindung

Vor diesem Hintergrund wird mit der vorliegenden Erfindung ein Bauelement, einen Nutzen aus entsprechenden Bauelementen sowie ein Verfahren zum Herstellen eines Bauelements gemäß den Hauptansprüchen vorgestellt. Vorteilhafte Ausgestaltungen ergeben sich aus den jeweiligen Unteransprüchen und der nachfolgenden Beschreibung.

Eine gefederte Lagerung für ein Bauelement kann durch ein Entkoppeln eines Trägers einer elektrischen Schaltung von einem Fußpunkt des Bauelements umgesetzt werden. Der Fußpunkt kann standardisierte Schnittstellen, wie eine Kugelgitteranordnung zum Integrieren in ein Steuergerät aufweisen. Die Entkopplung kann in einem Substratunterbau des Bauelements ausgeführt sein. Dadurch kann die elektrische Schaltung wie bei einem ungefederten Bauteil auf dem Träger angeordnet werden. Eine Masse eines Gehäuses für die elektrische Schaltung kann durch die Massenträgheit zur Entkopplung beitragen.

Es wird ein Bauelement mit folgenden Merkmalen vorgestellt:
einem Substrataufbau aus einer ersten Ebene aus einem Substrat und einer zweiten Ebene aus dem Substrat, wobei die erste Ebene einen relativ zu der zweiten Ebene beweglich gelagerten ersten Teilbereich und einen mechanisch mit der zweiten Ebene verbundenen zweiten Teilbereich aufweist, wobei zwischen dem ersten Teilbereich und dem zweiten Teilbereich federnde Strukturen aus der ersten Ebene ausgebildet sind und der erste Teilbereich Schnittstellen zum elektrischen und mechanischen Verbinden mit einer Leiterplatte aufweist und zwischen der ersten Ebene und der zweiten Ebene ein Hohlraum zum Ermöglichen einer Relativbewegung zwischen dem ersten Teilbereich der ersten Ebene und der zweiten Ebene angeordnet ist; und
einer elektrischen Schaltung, die auf der zweiten Ebene innerhalb eines Gehäuses angeordnet ist, wobei die Schaltung über den Substrataufbau elektrisch mit den Schnittstellen verbunden ist.

Weiterhin wird ein Nutzen mit folgendem Merkmal vorgestellt:
einer Mehrzahl von baugleichen Bauelementen gemäß dem hier vorgestellten Ansatz, wobei die Bauelemente in einem zeilenförmigen und/oder reihenförmigen Raster angeordnet sind, wobei die Ebenen der Substrataufbauten und/oder die Gehäuse als durchgehende Schichten ausgebildet sind, wobei zwischen den Bauelementen Sägegassen zum Vereinzeln der Bauelemente vorgesehen sind.

Die Hohlräume der Bauelemente können miteinander verbunden sein. Durch untereinander verbundene Hohlräume können alle Hohlräume von einem Punkt gemeinsam mit einer fließfähigen Substanz befüllt werden.

Schließlich wird ein Verfahren zum Herstellen eines Bauelements gemäß dem hier vorgestellten Ansatz vorgestellt, wobei das Verfahren die folgenden Schritte aufweist:
Bereitstellen eines Nutzen mit untereinander verbundenen Hohlräumen;
Anordnen des Nutzens in einer Form, die um den Nutzen umlaufend anliegt und den Nutzen an einer Auflagefläche abdichtet, um die Hohlräume abzudichten, wobei die Form zumindest einen Einspritzpunkt als Zugang zu den Hohlräumen aufweist;
Einbringen eines Gels in die Hohlräume durch den Einspritzpunkt, um das Kompressionsgel in die Hohlräume und/oder das Schergel in die federnden Strukturen einzubringen; und
Trennen des Nutzens entlang der Sägegassen, um die Bauelemente zu vereinzeln.

Unter einem Substrat kann ein Leiterplattenmaterial verstanden werden. Beispielsweise kann das Substrat ein Verbundmaterial, wie ein gewebeverstärkter Kunststoff sein. Beispielsweise kann das Substrat ein Leiterplattenmaterial sein. Das Substrat kann als Plattenware mit integrierten Leiterbahnen hergestellt werden und anschließend strukturiert werden. Insbesondere können Durchbrüche in das Plattenmaterial eingebracht werden. Der Substratunterbau kann Durchkontaktierungen senkrecht zu den Ebenen aufweisen, um die Ebenen elektrisch miteinander zu verbinden. Federnde Strukturen können als Biegefedern ausgebildete Materialstreifen aus Substrat sein, die an einem ersten Ende mit dem ersten Teilbereich verbunden sind und an einem gegenüberliegenden zweiten Ende mit dem zweiten Teilbereich verbunden sind. Die federnden Strukturen können beispielsweise als Mäander ausgebildet sein, um in unterschiedliche Raumrichtungen biegsam zu sein. Die federnden Strukturen können in unterschiedliche Raumrichtungen unterschiedliche Steifigkeiten bereitstellen. Schnittstellen können beispielsweise Lötstellen oder Klebestellen sein. Die Schnittstellen können dazu ausgebildet sein, über ein Zwischenmaterial die Verbindung zu einer Leiterplatte auszubilden. Das Zwischenmaterial kann einen Abstand zwischen dem Bauelement und der Leiterplatte herstellen. Ein Hohlraum kann durch eine Aussparung in dem Substrat gebildet werden. Unter einer elektrischen Schaltung kann dabei eine beliebige Schaltung verstanden werden, die elektrische Signale verarbeiten oder umwandeln kann. Beispielswiese kann eine elektrische Schaltung ein Sensor wie beispielsweise ein MEMS oder ein ASIC sein. Die elektrische Schaltung kann auf die zweite Ebene geklebt sein. Die elektrische Schaltung kann mit Kontaktdrähten elektrisch mit den Leiterbahnen des Substratunterbaus verbunden sein. Die elektrische Schaltung kann in einem Halbleitersubstrat ausgeführt sein. Die elektrische Schaltung kann auf einem Chip ausgeführt sein. Die Schnittstellen können über Leiterbahnen in dem ersten Teilbereich der ersten Ebene, den federnden Strukturen, dem zweiten Teilbereich der ersten Ebene, Durchkontaktierungen zu der zweiten Ebene und Leiterbahnen in der zweiten Ebene sowie Bonddrähte mit der elektrischen Schaltung verbunden sein. Ein Gehäuse kann aus einer Gießmasse ausgeführt sein. Das Gehäuse kann auch als Schutzhülle ausgeführt sein. Das Gehäuse kann auch in Form eines Deckels (Metall, Kunststoff) abgeschlossen werden. Ein Nutzen kann ein Produktionslos mehrerer gleichartiger Bauelemente umfassen, an denen jeweils zur Produktionsoptimierung gleiche Fertigungsschritte ausgeführt werden. Ein Fertigungsschritt kann dabei an allen Bauelementen gleichzeitig oder an allen Bauelementen nacheinander durchgeführt werden. Beispielsweise kann die erste Ebene aller Bauelemente gleichzeitig mit der zweiten Ebene aller Bauelemente verbunden werden, da die Ebenen als durchgehende Schichten bereitgestellt werden können. Die elektrischen Schaltungen aller Bauelemente können nacheinander angeordnet und verdrahtet werden. Eine Sägegasse kann zusätzliches Material enthalten, das beim Trennen entfernt wird. Eine Form kann eine Wanne sein, die die Umrisse des Nutzens abbildet. Ein Einspritzpunkt kann ein Anguss sein. Die Form kann Entlüftungsöffnungen aufweisen. Das Gel kann auch im Vakuum eingefüllt werden. Die Bauelemente können beispielsweise auseinandergesägt werden. Ebenso können die Bauelemente durch Wasserstrahlschneiden oder Laserschneiden getrennt werden.

Der Hohlraum des Substrataufbaus kann zumindest teilweise mit einem Kompressionsgel zwischen dem ersten Teilbereich der ersten Ebene und der zweiten Ebene gefüllt sein. In einem Bereich der federnden Strukturen kann ein Schergel zwischen dem ersten Teilbereich der ersten Ebene und dem zweiten Teilbereich der ersten Ebene angeordnet sein. Ein Kompressionsgel kann dazu ausgebildet sein, insbesondere Druck- und Zugkräfte zu absorbieren. Ein Schergel kann dazu ausgebildet sein, insbesondere Scherkräfte zu absorbieren. Das Kompressionsgel und/oder das Schergel kann schwingungsdämpfende Eigenschaften aufweisen. Das Kompressionsgel und das Schergel können aus dem gleichen Gel sein. Beispielsweise kann das Gel in den Hohlraum und/oder den Bereich der federnden Strukturen eingespritzt werden. Das Gel kann auch bei einem Zusammenfügen des Substrataufbaus als eigene Lage bzw. Gelmatte des Substrataufbaus eingefügt werden. Das Gel kann dabei ein Silikon, bzw. ein LSR (Liquid silicon rubber) aufweisen. Durch das Kompressionsgel und/oder das Schergel kann das Bauteil besonders gute schwingungsdämpfende Eigenschaften aufweisen.

Der Substrataufbau kann eine Zwischenebene aufweisen, die den zweiten Teilbereich der ersten Ebene mit der zweiten Ebene verbindet, wobei die Zwischenebene eine Höhe des Hohlraums definiert. Der zweite Teilbereich kann als eine, von dem ersten Teilteilbereich umschlossene Insel oder als ein, den ersten Teilbereich umschließender Rand ausgebildet sein. Die Zwischenebene kann aus dem Substrat sein. Die Zwischenebene kann Durchkontaktierungen aufweisen. Die Zwischenebene kann aus der ersten Ebene und/oder der zweiten Ebene durch einen Materialabtrag um die Zwischenebene herum herausgearbeitet worden sein. Durch die Zwischenebene kann ein definierter Abstand zwischen der ersten Ebene und der zweiten Ebene eingestellt werden.

Der Hohlraum des Substrataufbaus kann zumindest an einer Stelle mit einer Umgebung verbunden sein. Durch die Verbindung zur Umgebung kann das Gel in den Hohlraum eingespritzt werden. An der Stelle kann das Gel bei der Relativbewegung zur Umgebung ausweichen. Durch die Verbindung kann ein Überdruck in dem Gel verhindert werden.

Der Substrataufbau kann ein Ausgleichsgewicht aufweisen, wobei das Ausgleichsgewicht in dem zweiten Teilbereich der ersten Ebene angeordnet ist. Ein Ausgleichsgewicht kann eine Masseansammlung zum Beeinflussen eines Schwerpunkts des Bauelements sein. Das Ausgleichsgewicht kann ein um das Bauelement umlaufender Ring aus Metall sein, der auch als Leiterbahn verwendet werden kann. Durch das Ausgleichsgewicht kann ein Schwingungsverhalten des Bauelements positiv beeinflusst werden.

Das Gehäuse kann einen elektrisch leitfähigen Schirm aufweisen, der dazu ausgebildet ist, die elektrische Schaltung vor elektromagnetischen Störungen abzuschirmen. Ein Schirm kann eine dünne Schicht Metall oder eine Metallzugabe zu einer abschließenden Schicht des Gehäuses sein. Der Schirm kann auch als Deckel aus Metall ausgeführt sein. Der Schirm kann elektrisch mit einem Nullpotenzial verbunden sein. Durch den Schirm kann das Bauelement in einer elektromagnetisch gestörten Umgebung sicher betrieben werden.

Die elektrische Schaltung kann zumindest einen mikroelektromechanischen Sensor umfassen. Dann kann das Bauelement ein Sensorelement sein. Insbesondere kann das Bauelement zumindest einen Beschleunigungsaufnehmer oder Drehratenaufnehmer aufweisen. Das Bauelement kann dazu ausgebildet sein, über die Schnittstellen mit einer Platine eines Steuergeräts eines Fahrzeugs verbunden zu werden, um beispielsweise sicherheitsrelevante Beschleunigungssignale oder Drehratensignale für das Steuergerät bereitzustellen.

Die Erfindung wird nachstehend anhand der beigefügten Zeichnungen beispielhaft näher erläutert. Es zeigen:
- Fig. 1: ein Blockschaltbild eines Bauelements gemäß einem Ausführungsbeispiel der vorliegenden Erfindung;
- Fig. 2: eine Schnittdarstellung eines Bauelements gemäß einem Ausführungsbeispiel der vorliegenden Erfindung;
- Fig. 3: eine Darstellung verschiedener Ebenen eines Substratunterbaus eines Bauelements gemäß einem Ausführungsbeispiel der vorliegenden Erfindung;
- Fig. 4: eine Schnittdarstellung eines Bauelements gemäß einem weiteren Ausführungsbeispiel der vorliegenden Erfindung
- Fig. 5: eine Darstellung einer ersten Ebene eines Substratunterbaus eines Bauelements gemäß einem weiteren Ausführungsbeispiel der vorliegenden Erfindung;
- Fig. 6: eine Schnittdarstellung eines Bauelements mit einem Kompressionsgel gemäß einem Ausführungsbeispiel der vorliegenden Erfindung;
- Fig. 7: eine Schnittdarstellung eines Bauelements mit einem Schergel gemäß einem Ausführungsbeispiel der vorliegenden Erfindung;
- Fig. 8: eine Schnittdarstellung eines Bauelements mit einem Kompressionsgel und einem Schergel gemäß einem Ausführungsbeispiel der vorliegenden Erfindung;
- Fig. 9: eine Schnittdarstellung eines Bauelements mit einem Kompressionsgel und einem Schergel gemäß einem weiteren Ausführungsbeispiel der vorliegenden Erfindung;
- Fig. 10: eine Schnittdarstellung eines Bauelements mit einem strukturierten Kompressionsgel gemäß einem Ausführungsbeispiel der vorliegenden Erfindung;
- Fig. 11: eine Darstellung eines Bauelements mit seitlicher Öffnung des Hohlraums gemäß einem Ausführungsbeispiel der vorliegenden Erfindung;
- Fig. 12: eine Darstellung eines Bauelements mit Öffnungen in der ersten Ebene gemäß einem Ausführungsbeispiel der vorliegenden Erfindung;
- Fig. 13: eine Schnittdarstellung eines Bauelements mit einem Ausgleichsgewicht in der ersten Ebene gemäß einem Ausführungsbeispiel der vorliegenden Erfindung;
- Fig. 14: eine Schnittdarstellung eines Bauelements mit einem geschirmten Gehäuse gemäß einem Ausführungsbeispiel der vorliegenden Erfindung;
- Fig. 15: eine Schnittdarstellung eines Bauelements mit einem schirmenden Deckel gemäß einem Ausführungsbeispiel der vorliegenden Erfindung;
- Fig. 16: eine Schnittdarstellung eines Bauelements mit einer weiteren elektrischen Schaltung gemäß einem Ausführungsbeispiel der vorliegenden Erfindung;
- Fig. 17: eine Schnittdarstellung eines Bauelements mit einem Opfermaterial zum Herstellen des Hohlraums gemäß einem Ausführungsbeispiel der vorliegenden Erfindung;
- Fig. 18: eine Schnittdarstellung eines Bauelements mit einem fünfschichtigen Substratunterbau gemäß einem Ausführungsbeispiel der vorliegenden Erfindung;
- Fig. 19: eine Darstellung eines Nutzen gemäß einem Ausführungsbeispiel der vorliegenden Erfindung;
- Fig. 20: eine Darstellung eines Nutzen gemäß einem weiteren Ausführungsbeispiel der vorliegenden Erfindung;
- Fig. 21: eine Schnittdarstellung eines Nutzen gemäß einem Ausführungsbeispiel der vorliegenden Erfindung;
- Fig. 22: eine Schnittdarstellung eines Nutzen gemäß einem weiteren Ausführungsbeispiel der vorliegenden Erfindung;
- Fig. 23: eine Schnittdarstellung eines fünfschichtigen Nutzen gemäß einem Ausführungsbeispiel der vorliegenden Erfindung;
- Fig. 24: eine Schnittdarstellung eines fünfschichtigen Nutzen gemäß einem weiteren Ausführungsbeispiel der vorliegenden Erfindung; und
- Fig. 25: ein Ablaufdiagramm eines Verfahrens zum Herstellen eines Bauelements gemäß einem Ausführungsbeispiel der vorliegenden Erfindung.

In der nachfolgenden Beschreibung bevorzugter Ausführungsbeispiele der vorliegenden Erfindung werden für die in den verschiedenen Figuren dargestellten und ähnlich wirkenden Elemente gleiche oder ähnliche Bezugszeichen verwendet, wobei auf eine wiederholte Beschreibung dieser Elemente verzichtet wird.

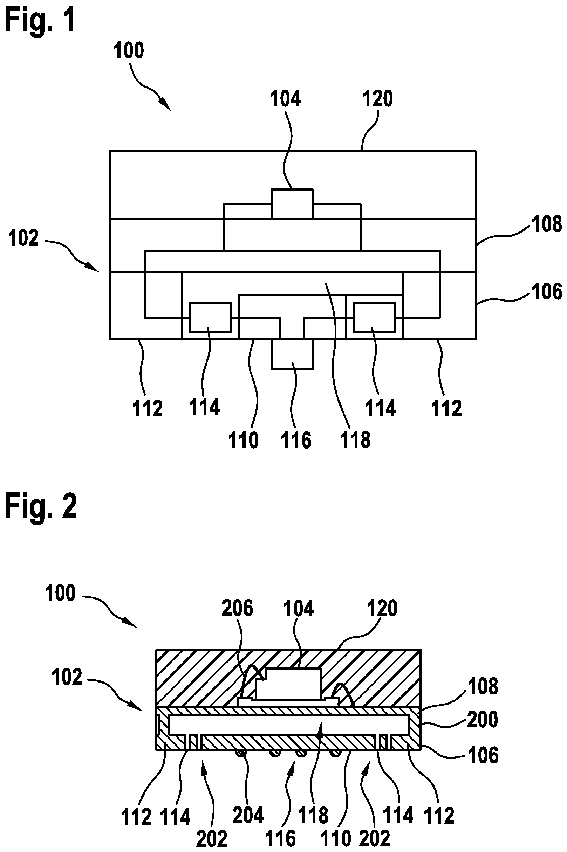

Fig. 1 zeigt ein Blockschaltbild eines Bauelements 100 gemäß einem Ausführungsbeispiel der vorliegenden Erfindung. Das Bauelement 100 weist einen Substratunterbau 102 und eine elektrische Schaltung 104 auf. Der Substrataufbau 102 weist eine erste Ebene 106 und eine zweite Ebene 108 auf. Die erste Ebene 106 und die zweite Ebene 108 sind aus einem Substrat, beispielsweise einem Leiterplattenmaterial. Die erste Ebene 106 weist einen relativ zu der zweiten Ebene 108 beweglich gelagerten ersten Teilbereich 110 und einen mechanisch und/oder elektrisch mit der zweiten Ebene verbundenen zweiten Teilbereich 112 auf. Zwischen dem ersten Teilbereich 110 und dem zweiten Teilbereich 112 sind federnde Strukturen 114 als Teil der ersten Ebene 106 ausgebildet. Der erste Teilbereich 110 weist Schnittstellen 116 zum elektrischen und mechanischen Verbinden mit einer nicht dargestellten Leiterplatte auf. Zwischen der ersten Ebene 106 und der zweiten Ebene 108 ist ein Hohlraum 118 zum Ermöglichen einer Relativbewegung zwischen den Schnittstellen 116 und der zweiten Ebene 108 angeordnet. Die elektrische Schaltung 104 ist auf der zweiten Ebene 108 innerhalb eines Gehäuses 120 angeordnet. Die Schaltung 104 ist über den Substrataufbau 102 elektrisch mit den Schnittstellen 116 verbunden. Die elektrische Schaltung 104 (beispielsweise MEMS und/oder ASIC) können. jeweils auf Waferbasis hergestellt und anschließend vereinzelt werden. Die Wafer-Stücke (wie MEMS und/oder ASIC) werden auf das Substrat gesetzt und auf der zweiten Ebene 108 befestigt.

Durch Vibrationsbelastung kann ein Substratunterbau 102 oder Schaltungsträger 102 eine Bauelements 100 oder einer Sensoranordnung 100 und/oder ein Gehäuse 120 der Sensoranordnung 100 zu Schwingungen angeregt werden. Diese Schwingungen können schädlich für das die elektrische Schaltung 104 oder ein Sensorelement 104 sein, welches auf dem Schaltungsträger 102 und/oder in dem Gehäuse 120 angeordnet ist. Üblicherweise ist das Sensorelement 104 eingemoldet, wobei die äußeren Ausmaße des Gehäuses 120 der Sensoranordnung 100, von dem Gusswerkzeug abhängig sind. Denkbar ist auch die Verwendung eines Deckels um das Sensorelement 104. Die Außenmaße des Gehäuses sind beispielsweise durch die Sägestraße definiert. Die Ausmaße des Gusswerkzeugs definieren somit vorzugsweise die Abmessungen eines Mold-Nutzen. Um die Sensoranordnung 100 mit einer Leiterplatte elektrisch zu kontaktierten und/oder mechanisch zu verbinden weist das Gehäuse 120 der Sensoranordnung 100 als Schnittstelle 116 eine sogenannte Kugelgitteranordnung 116 (Ball Grid Array, BGA) auf. Auch ist die Verwendung eines LGA (LGA = Land Grid Array) zur Kontaktierung denkbar.

Fig. 2 zeigt eine Schnittdarstellung eines Bauelements 100 gemäß einem Ausführungsbeispiel der vorliegenden Erfindung. Das Bauelement 100 entspricht dem Bauelement in Fig. 1. Zusätzlich weist der Substratunterbau 102 eine Zwischenlage 200 auf. Die Zwischenlage 200 ist zwischen der ersten Ebene 106 und der zweiten Ebene 108 angeordnet. Die Zwischenebene 200 verbindet den zweiten Teilbereich 112 der ersten Ebene 106 mit der zweiten Ebene 108. Die Zwischenebene 200 ist als Rand ausgebildet und umschließt den Hohlraum 118. Der zweite Teilbereich 112 ist ebenfalls als umlaufender Rand ausgebildet. Der erste Teilbereich 110 ist als Insel in dem zweiten Teilbereich 112 ausgebildet. Der erste Teilbereich 110 ist von einem Durchbruch 202 zwischen dem ersten Teilbereich 110 und dem zweiten Teilbereich 112 von dem zweiten Teilbereich 112 getrennt. Der Durchbruch 202 wird durch die federnden Strukturen 114 überbrückt. Die federnden Strukturen 114 sind hier als Biegebalken 114 ausgebildet, die im Wesentlichen an dem Durchbruch 202 ausgerichtet sind. In der Darstellung in Fig. 2 sind die Biegebalken 114 quer zu einer Haupterstreckungsrichtung der Biegebalken 114 geschnitten dargestellt. An gegenüberliegenden Enden sind die Biegebalken 114 an dem ersten Teilbereich 110 und dem zweiten Teilbereich 112 befestigt. Der erste Teilbereich 106 weist an den Schnittstellen 116, zum Löten vorbereitete Lotkugeln 204 auf Kontaktflächen auf, die in einem Raster auf einer Unterseite des ersten Teilbereichs 110 angeordnet sind. Die elektrische Schaltung 104 ist in dem Gehäuse 120 eingegossen. Das Gehäuse 120 besteht aus einer Gussmasse, die die elektrische Schaltung 104 vollständig umschließt. Die elektrische Schaltung 104 ist mit Verbindungsdrähten 206 elektrisch mit der zweiten Ebene 108 des Substratunterbaus 102 verbunden.

Gemäß einem Ausführungsbeispiel zeigt Fig. 2 als Substratunterbau 102 ein vibrationsentkoppelndes Substrat 102 zur vereinfachten Montage und Baugrößenreduktion mit einer Inertialsensorik 104 als elektrische Schltung 104. Hochauflösende Inertialsensoren 104 für beispielsweise ESP-Anwendungen können direkt im Steuergerät (SG) (ESPi-SG oder Airbag-SG) und damit an Positionen mit hoher Vibrationsbelastung eingesetzt werden. Um Vibrationen zu dämpfen, kann in einem Bauelement 100 als First-Level-Modul 100 ein mechanischer Dämpfer integriert werden oder es können Premoldgehäuse mit integriertem Dämpfer eingesetzt werden. Der hier vorgestellte Ansatz beschreibt eine Dämpfung für gängige mikroelektronische Gehäuse aus Moldmasse oder mit Metalldeckel 120. Der hier vorgestellte Ansatz ist kostengünstig. Speziell bei modernen LGA/BGA-Gehäusen 120 ist eine wirksame Entkopplung von Leiterplatte und Sensor 104 wichtig, da das Gehäuse 120 über keine Leads verfügt, welche bei etwa SOIC Gehäusen noch für eine gewisse Vibrationsentkopplung sorgen.

Bei dem hier vorgestellten Dämpfer 102 ist beispielsweise das Einbringen eines Dämpferelastomers zwischen die balkenähnlichen Strukturen 114 sehr gut im Nutzen möglich, da kein zusätzlicher Platzbedarf durch Tabuzonen zwischen Elastomer und den elektrischen Kontakten erforderlich ist. Bei dem hier vorgestellten Ansatz kann dieses Dämpferelastomer direkt vom Leiterplattenhersteller eingebracht werden, wodurch Kosten gespart werden. Wenn der Substratunterbau 102 separat auf der Leiterplatte befestigt wird, kann das LGA/BGA-Gehäuse auf diesem Interposer mit einem weiteren Löt-Schritt aufgebracht werden und die Gesamtbauhöhe kann erhöht werden.

Der hier vorgestellte Ansatz zeigt eine kostengünstige, klein bauende 1st-Level Aufbau- und Verbindungstechnik zur Entkopplung von Vibrationen in allen drei Raumrichtungen. Durch die Entkopplung wird eine Störanfälligkeit von MEMS-Sensoren 104 am Einbauort verringert. Die schwingungsentkoppelnde Struktur 102 ist hier im 1st-Level und somit direkt in der Leiterplatte 102 des eigentlichen LGA/BGA-Gehäuses 120 integriert.

Der Substratunterbau 102 besteht aus drei Substratebenen 106, 108, 200 welche einen Hohlraum 118 einschließen. Mindestens eine der sechs Seiten, welche den Hohlraum 118 definieren, kann mindestens teilweise geöffnet sein.

Die untere 106 dieser drei Substratebenen besteht aus zwei Teilen 110, 112. Der erste Teil 110 ist einer Insel und der zweite Teil 112 ist ein umlaufend geschlossener Ring. Beide Teile 110, 112 (Insel + Ring) sind über dünne balkenähnliche Strukturen 114 miteinander mechanisch und elektrisch verbunden. Diese balkenähnlichen Strukturen 114 sind so ausgelegt, dass Vibrationen von der Insel 110 zum Ring 112 (oder andersherum) gedämpft werden.

Die mittlere Substratebene 200 verbindet die obere 108 und untere 106 Substratebene mechanisch und elektrisch.

Die obere 108 und die untere 112 Substratebene beinhalten metallisierte Kontaktflächen 116 zur elektrischen und mechanischen Ankopplung an Bauelemente oder andere Substrate.

Alle drei Substratebenen 106, 108, 200 können Metallisierungslagen enthalten. Außerdem können elektrische Signale durch Vias von der Oberseite auf die Unterseite (oder andersherum) geleitet werden.

Die obere Substratebene 108 ist mit mindestens einem MEMS/ASIC 104 bestückt, der mittels kleben+Drahtbonds oder Leitkleben befestigt ist und mit einer Moldmasse 120 oder einem Deckel (z. B. Metall, Kunststoff) gehaust ist. Die MEMS/ASIC können auch als FlipChip in einem Löt- oder Klebeschritt aufgebracht werden. Die untere Substratebene 106 kann im Bereich der Insel 110 mit einem weiteren Substrat durch Lötballs 204 oder Leitkleben elektrisch und mechanisch verbunden werden, wobei die Lötballs 204 oder der Leitkleber einen Stand-off (Abstand) erzeugen. Die mittlere Substratebene 200 begrenzt den Hohlraum 118 lateral.

Der hier vorgestellte Ansatz erzeugt eine kompakte Struktur 102 zur Entkopplung von mechanischen Schwingungen, wodurch sich ein hohes Potenzial für Kostenersparnis ergibt.

Durch die Federbalken 114, welche zwischen den Bauelementen 104 und den Lötkontakten 116 an der unteren Substratebene 106 ausgeprägt sind, wird thermomechanischer und mechanischer Stress, welcher durch die Lötkontaktierung von weiteren Substraten eingebracht werden kann, entkoppelt. Dadurch wird der Drift und Offset der Sensorsignale deutlich verringert.

Durch die Integration der dämpfenden Strukturen 114 (= Federbalken) in das 1st-Level, also direkt in das BGA/LGA-Gehäuse 120 ist eine weitere Bauhöhenreduktion möglich, was zur Reduktion von Material und Kosten beiträgt.

Durch diesen 1st-Level-Dämpfer 102 wird der Applikationsaufwand reduziert, da mindestens ein Lötschritt zum Auflöten des LGA/BGA-Gehäuses auf den Interposer weniger notwendig ist. Der Lötschritt entfällt.

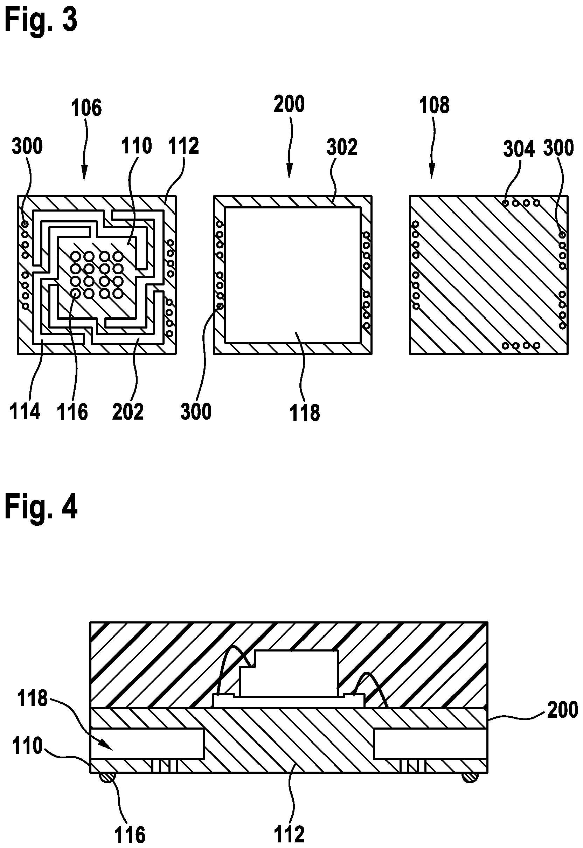

Fig. 3 zeigt eine Darstellung verschiedener Ebenen 106, 108, 200 eines Substratunterbaus eines Bauelements gemäß einem Ausführungsbeispiel der vorliegenden Erfindung. Der Substratunterbau entspricht dem Substratunterbau in Fig. 2. Die Ebenen 106, 108, 200 sind einzeln dargestellt. Die Ebenen 106, 108, 200 sind vor einem Fügeprozess dargestellt. Die erste Ebene 106 weist den ersten Teilbereich 110 mit den im Raster angeordneten Schnittstellen 116, den Durchbruch 202, die als Biegebalken 114 ausgebildeten federnden Strukturen 114 und den zweiten Teilbereich 112 auf. Der erste Teilbereich 110 ist als Insel ausgebildet. Die Biegebalken 114 oder Federbalken 114 sind als Mäander ausgebildet. Der zweite Teilbereich 112 ist als ringförmig geschlossen umlaufender Rand ausgebildet. Der zweite Teilbereich 112 weist Durchkontaktierungen 300 oder Vias auf. Die Vias sind über Leiterbahnen in den Federbalken 114 und der ersten Ebene 106 mit den Schnittstellen 116 verbunden. Die Zwischenebene 200 ist als ringförmig geschlossen um den Hohlraum 118 umlaufender Ring 302 ausgebildet. Die Zwischenebene 200 weist ebenso Durchkontaktierungen 300 auf. Die zweite Ebene 108 ist als durchgehende Fläche ausgebildet. Die zweite Ebene weist ebenfalls Durchkontaktierungen 300 und Kontaktpads 304 auf. Die Kontaktpads 304 sind über Leiterbahnen in der zweiten Ebene 108 mit den Durchkontaktierungen verbunden. Die Durchkontaktierungen 300 werden für den Fügeprozess fluchtend übereinander angeordnet und elektrisch miteinander verbunden, um durchgehende elektrische Leitungen zwischen den Kontaktpads 304 und den Schnittstellen 116 herzustellen.

In den Figuren 2 und 3 ist ein detaillierter Aufbau einer grundlegenden Ausführungsvariante eines Bauelements 100 gezeigt. Das hier vorgeschlagene Konzept dient als 1st-Level-Dämpfer für z. B. Inertialsensoren 104.

Die erste Substratebene 106 beinhaltet auf der Unterseite der Insel 110 metallisierte Flächen 116 zur elektrischen und mechanischen Anbindung auf einem weiteren Substrat. Des Weiteren enthält die erste Substratebene 106 mehrere Lagen Metallisierung (z. B. Cu), sodass eine elektrische Verbindung zwischen diesen einzelnen Lagen vorhanden ist. Der äußere Ring 112 der ersten Substratebene 106 beinhaltet elektrische Vias zu den zweiten 200 und dritten 108 Substratebenen. Die zweite Substratebene 200 ist hier die Zwischenebene 200. Die Federbalkenstrukturen 114 in der ersten Substratebene 106 dienen als Federsystem, um externe Vibrationen vom Ring 112 in der ersten Substratebene 106, aber besonders von der zweiten 200 und dritten 108 Substratebene, und damit von den Sensoren 104 auf der Oberseite des Substrates 102 (auf der dritten Substratebene 108), zu entkoppeln. Es sind auch andere Ausführungsvarianten der Federbalkenstrukturen 114 denkbar. Die gezeigte Variante ist nur ein Beispiel. Die zweite Substratebene 200 bildet einen Rahmen und schließt somit den Hohlraum 118 seitlich ab. Es sind aber auch Ausführungsformen mit seitlicher Öffnung möglich, um Arbeitsräume für ein Dämpferelastomer und die Möglichkeit zur Vergelung im Nutzen zu geben. Die dritte Substratebene 108 ist die eigentliche Substratoberfläche für die Sensoren 104, welche mittels Kleben und Drahtbonden oder Flip-Chip-Technologien (z. B. löten) elektrisch und mechanisch aufgebracht werden. Auch diese Substratebene 108 kann mehrere Lagen Metallisierung beinhalten.

Der hier vorgestellte Ansatz kann bei vibrationsempfindlichen MEMS-Sensoren 104 im Automotive- oder Consumer-Bereich eingesetzt werden. Bespielweise können ESP-Systeme oder Airbag-Anwendungen bestehend aus Drehraten- und Beschleunigungssensor 104 vor Vibrationen geschützt werden, welche sich als vibrationsempfindlich darstellen können.

Die Herstellung des gesamten Substrates 102 ist in Form einer Leiterplatte mit Standardtechniken möglich. Die einzelnen Substratebenen 106, 108, 200 können unabhängig voneinander hergestellt und anschließend miteinander verpresst oder in Laminiertechnik verklebt werden. Nach dem Prozessieren der elektrischen Vias durch die Substratebenen 106, 108, 200 können die Federbalken 114 mittels Fräsen/Lasern/Sandstrahl strukturiert werden.

Es ist allerdings auch möglich die Federbalken 114 vor dem Verpressen der Substratebenen 106, 108, 200 zu strukturieren. In diesem Fall kann vordem Metallisieren (typischerweise mittels Galvanik) der Vias die Öffnung zum Hohlraum 118 wegen der jetzt bereits eingebrachten Federbalkenstrukturen 114 gegebenenfalls mit einer temporären Schutzschicht bedeckt werden, um das Abscheiden von Metall im Hohlraum 118 zu verhindern.

In einer weiteren Herstellungsvariante ist es möglich, die zweite Substratebene 108 und die Zwischenebene 200 mittels Sackloch-Fäsen zu strukturieren und damit aus einem Basissubstrat herzustellen. Alle genannten Herstellungsverfahren ergeben aber die gleich finale Substratstruktur 102 mit den gleichen Eigenschaften.

Fig. 4 zeigt eine Schnittdarstellung eines Bauelements 100 gemäß einem weiteren Ausführungsbeispiel der vorliegenden Erfindung. Das Bauelement 100 entspricht dem Bauelement in den Figuren 1 und 2. Im Gegensatz zu den Figuren 2 und 3 ist hier der erste Teilbereich 110 mit den Schnittstellen 116 als Ring ausgebildet. Der zweite Teilbereich 112 ist als die Insel ausgebildet. Dadurch ist auch die Zwischenebene 200 als von dem Hohlraum 118 umschlossene Insel ausgebildet.

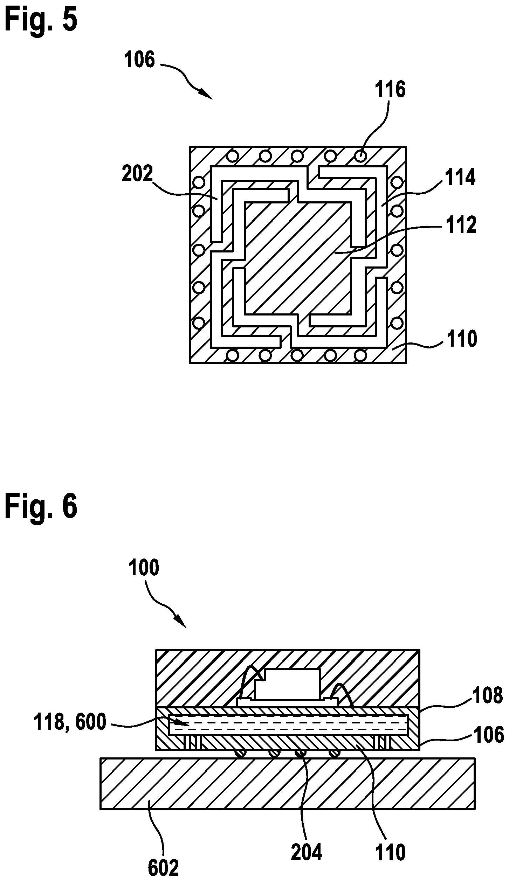

Fig. 5 zeigt eine Darstellung einer ersten Ebene 106 eines Substratunterbaus eines Bauelements gemäß einem weiteren Ausführungsbeispiel der vorliegenden Erfindung. Die erste Ebene 106 entspricht der ersten Ebene des Bauelements in Fig. 4. Die Schnittstellen 116 sind hierauf dem ringförmig um den Durchbruch 202 umlaufenden ersten Teilbereich 110 angeordnet. Der zweite Teilbereich 112 ist als Insel in dem Durchbruch 202 angeordnet. Die federnden Strukturen 114 sind wie in Fig. 3 als Mäander ausgeführt, um in mehreren Raumrichtungen flexibel zu sein.

Als ein Ausführungsbeispiel zeigen die Figuren 4 und 5 ein vibrationsentkoppelndes Substrat 102 zur vereinfachten Vergelung. Bei der Verpackung von mikromechanischen Sensoren 104 kann es zum Teil zwingend notwendig sein, störende Schwingungen vom Sensorelement 104 fernzuhalten. Am Einbauort sind die gehäusten mikromechanischen Sensoren 100 unterschiedlichen Belastungen durch die Umweltbedingungen ausgesetzt. Ein besonderer Einfluss ist dabei die Vibrationsbelastung, wie sie unter anderem für ESP-Sensoren im Steuergerät auftreten. Um die Sensoren 104 vor diesen Vibrationen zu schützen bzw. zu entkoppeln können innerhalb des Sensorgehäuses 120 spezielle Dämpferstrukturen 114 und Dämpfermaterialien eingebracht werden. Die Dämpfer können auch als externe Dämpfer ausgeführt werden. Der hier vorgestellte Ansatz beschreibt eine kostengünstige Lösung für moderne Moldgehäuse 120. Speziell bei modernen LGA/BGA Gehäusen ist eine wirksame Entkopplung von Leiterplatte und Sensor 104 wichtig, da das Gehäuse 120 über keine Leads verfügt, welche bei etwa SOIC Gehäusen noch für eine gewisse Vibrationsentkopplung sorgen.

Der hier vorgestellte Ansatz stellt eine Dämpfungsanordnung 102 vor, um Schwingungen, welche über eine Leiterplatte auf ein Gehäuse 120 einer Sensoranordnung 100 übertragen werden, zu dämpfen oder um das Gehäuse 120 von der Leiterplatte zu entkoppeln. Die Sensoranordnung 100 umfasst hierbei mindestens ein Gehäuse 120 mit einem eingemoldeten, schwingungsempfindlichen und/oder vibrationsempfindlichen Sensorelement 104. Die Dämpfungsanordnung 102 umfasst eine erste, in der Darstellung obere Ebene 108 und eine zweite, in der Darstellung untere Ebene 106. Die beiden Ebenen 106, 108 weisen jeweils metallisierte Kontaktflächen und Leiterbahnen zur elektrischen Kontaktierung von Bauelementen, wie beispielsweise der Sensoranordnung 104 und/oder zur Kontaktierung weiterer Ebenen auf. Die Kontaktflächen der beiden Ebenen 106, 108 weisen in entgegengesetzte Raumrichtungen. Des Weiteren weist die Dämpfungsanordnung 102 ein mittleres Anordnungselement 200 auf. Die obere Ebene 108 erstreckt sich lateral über die Fläche des gehausten Bauelements 104 und ist der Träger der elektrischen Schaltung 104, hier des Bauelements 104. Das mittlere Anordnungselement 200 ist zentrisch angeordnet und verbindet die obere 108 und die untere 106 Ebene miteinander. Des Weiteren weist das mittlere Anordnungselement 200 metallisierte Durchkontakte auf, welche die Kontaktflächen der oberen Ebene 108 mit den Kontaktflächen des unteren Substratteils 106 elektrisch verbinden. Die untere Ebene 106 ist als Ring ausgeführt, welcher über sogenannte Federbalken 114 mit dem mittleren Anordnungselement 200 verbunden ist. Die Dämpfungsanordnung umfasst einen Hohlraum 118, welcher umlaufend um das mittlere Anordnungselement 200 angeordnet ist und von der oberen 108 und der unteren Ebene 106 begrenzt wird. Der Hohlraum 118 stellt die Balkenstrukturen 114 der unteren Ebene 106 frei. Die Dämpfungsanordnung 102 weist mindestens eine Öffnung auf, über die der Hohlraum 118 mit einem dämpfenden Material wie beispielsweise Gel gefüllt werden kann. Des Weiteren weist die untere Ebene 106 am Ring 110 eine sogenannte Kugelgitteranordnung 116 (Ball Grid Array, BGA) auf, um die Dämpfungsanordnung 102 mit einer nicht dargestellten Leiterplatte zu verbinden. Auch die Anbindung mit einem LGA ist prinzipiell denkbar.

Fig. 6 zeigt eine Schnittdarstellung eines Bauelements 100 mit einem Kompressionsgel 600 gemäß einem Ausführungsbeispiel der vorliegenden Erfindung. Das Bauelement 100 entspricht dem Bauelement in Fig. 2. Zusätzlich ist das Bauelement 100 in verbautem Zustand dargestellt. Das Bauelement 100 ist über die Lotkugeln 204 mit einer Leiterplatte 602 verbunden. Weiterhin ist der Hohlraum 118 mit einem Kompressionsgel 600 gefüllt. Das Kompressionsgel 600 ist dazu ausgebildet, Zugkräfte und Druckkräfte zwischen der zweiten Ebene 108 und dem ersten Teilbereich 110 der ersten Ebene 106 aufzunehmen und resultierende Schwingungen zu dämpfen.

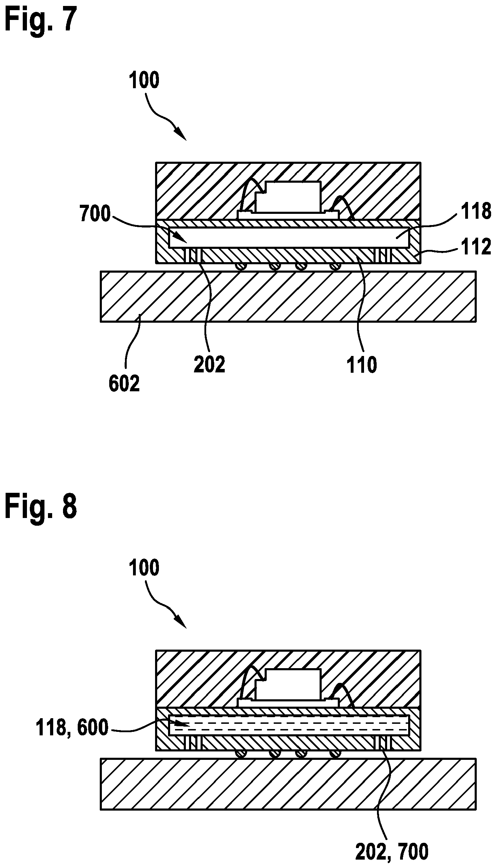

Fig. 7 zeigt eine Schnittdarstellung eines Bauelements 100 mit einem Schergel 700 gemäß einem Ausführungsbeispiel der vorliegenden Erfindung. Das Bauelement 100 entspricht dem Bauelement in Fig. 2. Wie in Fig. 6 ist das Bauelement 100 in verbautem Zustand auf der Leiterplatte 602 dargestellt. Im Gegensatz zu Fig. 6 ist der Hohlraum 118 leer. Hier ist ein Schergel 700 in dem Durchbruch 202 angeordnet, um Scherkräfte zwischen dem ersten Teilbereich 110 und dem zweiten Teilbereich 112 aufzunehmen und resultierende Schwingungen zu dämpfen.

Fig. 8 zeigt eine Schnittdarstellung eines Bauelements 100 mit einem Kompressionsgel 600 und einem Schergel 700 gemäß einem Ausführungsbeispiel der vorliegenden Erfindung. Das Bauelement 100 entspricht dem Bauelement in den Figuren 6 und 7. Hier ist der Hohlraum 118 mit dem Kompressionsgel 600 aufgefüllt. Der Durchbruch 202 ist mit dem Schergel 700 aufgefüllt.

Jeder Dämpfer 102 funktioniert als Tiefpass, sodass nur Schwingungen jenseits seiner Resonanzfrequenz stark gedämpft werden. Insbesondere im Bereich der Resonanzfrequenz können die Schwingungen überhöht (also verstärkt) werden. Die Überhöhung kann durch Einbringen von Dämpferelastomeren 600 in den Hohlraum 118 und/oder Dämpferelastomeren 700 zwischen die Federbalkenstrukturen 114 signifikant reduziert werden. In Fig. 6 ist das Dämpferelastomer 600 in den Hohlraum 118 als Kompressionsgel 600 bezeichnet. In Fig. 7 ist das Dämpferelastomer 700 zwischen den Federbalkenstrukturen 114 als Schergel 700 bezeichnet. In Fig. 8 ist die Kombination aus Dämpferelastomer 600 in dem Hohlraum 118 und Dämpferelastomer 700 zwischen den Federbalkenstrukturen 114 als mit Kompressionsgel 600 und Schergel 700 bezeichnet. Das Kompressionsgel 600 dämpft hierbei besonders Schwingungen in der "out-of-plane" Richtung, das Schergel 700 besonders in der "in-plane" Richtung. Je nach Härte des eingesetzten Elastomers 600, 700, wirkt dieses auch als zur Federbalkenstruktur 114 parallel geschaltete Elastomerfeder und trägt somit zur Festlegung der Resonanzlage mit bei.

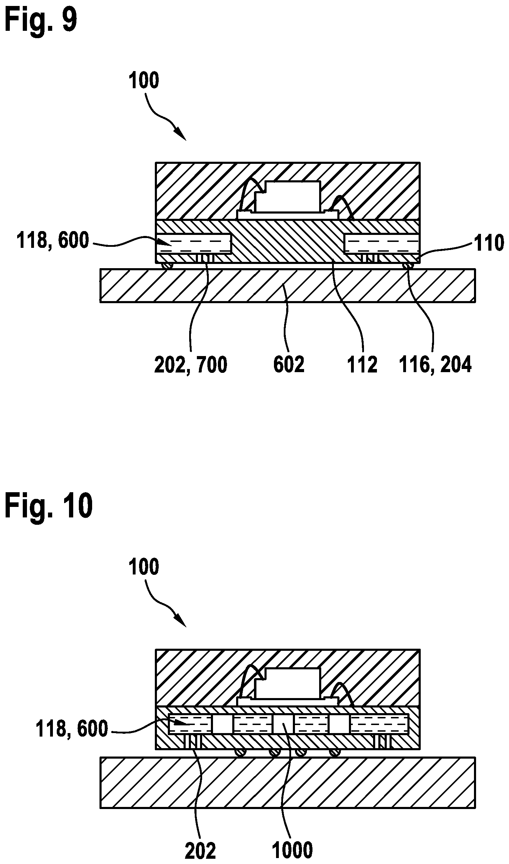

Fig. 9 zeigt eine Schnittdarstellung eines Bauelements 100 mit einem Kompressionsgel 600 und einem Schergel 700 gemäß einem weiteren Ausführungsbeispiel der vorliegenden Erfindung. Das Bauelement 100 entspricht dem Bauelement in Fig. 4. Wie in den Figuren 6 bis 8 ist das Bauelement 100 auf einer Leiterplatte 602 befestigt dargestellt. Wie in Fig. 4 ist der erste Teilbereich 110 als Ring ausgeführt. Der zweite Teilbereich 112 ist als Insel ausgeführt. Der Hohlraum 118 ist um die Insel herum angeordnet und mit dem Kompressionsgel 600 aufgefüllt. Der Durchbruch 202 ist mit dem Schergel 700 aufgefüllt.

Gemäß einem Ausführungsbeispiel zeigt Fig. 9 eine Ausführungsform eines Systems 100 nach dem hier vorgestellten Ansatz. Das System 100 ist aufgebracht auf einem Trägersubstrat 602. Die elektrische und mechanische Kontaktierung erfolgt durch Löten der Lotballs 204. Über den Pitch der Lotballs 204 kann ein weiterer Partikelschutz erfolgen. Die Balkenstruktur 114, welche den unteren als Ring ausgeprägten Substratteil 110 mit dem mittleren Substratteil 200 "Substratinsel" verbindet, ist exemplarisch dargestellt, andere Balkenstrukturen 114 sind denkbar. Die Balkenstrukturen 114 tragen isolierte Leiterbahnen, welche die Durchkontakte des mittleren Substratteils 112 mit den Pads 116 der Lötkontakte des unteren Substratteils 110 verbinden.

Fig. 10 zeigt eine Schnittdarstellung eines Bauelements 100 mit einem strukturierten Kompressionsgel 600 gemäß einem Ausführungsbeispiel der vorliegenden Erfindung. Das Bauelement 100 entspricht dem Bauelement in Fig. 6. Der Durchbruch 202 ist frei von Schergel. Das Kompressionsgel 600 füllt den Hohlraum 118 unvollständig. Das Kompressionsgel 600 weist Aussparungen 1000 auf. Beispielsweise können die Aussparungen 1000 als Ausweichvolumen dienen, wenn das Kompressionsgel 600 komprimiert wird. Dadurch kann das Kompressionsgel 600 eine geringere Härte aufweisen, als das durchgehende Kompressionsgel in Fig. 6.

Zur Herstellung, also dem Einbringen des Elastomers (der Vergelung der Systeme 100) sind prinzipiell zwei Konzepte ausführbar. Der Elastomer kann während der Herstellung der Substrate und/oder nach der Herstellung der Substrate eingebracht werden.

Die Vergelung während der Herstellung der Substrate 102 bietet dabei ein hohes Potenzial zur Kostenreduktion. Beispielsweise kann das Gel 600 als Elastomermatte direkt während der Herstellung des Substrats 102 integriert werden. Diese Embedding-Technik kann direkt durchgeführt werden. Alternativ ist das Einbringen des Dämpfergels 600 mittels Schablonendruck, Dispensen, Siebdruck oder Rakeln möglich. Wie in Fig. 10 kann beim Embedding die Auflagefläche des Kompressionsgels 600 eingestellt werden und das Dämpfungsvermögen des Gesamtsystems 100 angepasst werden.

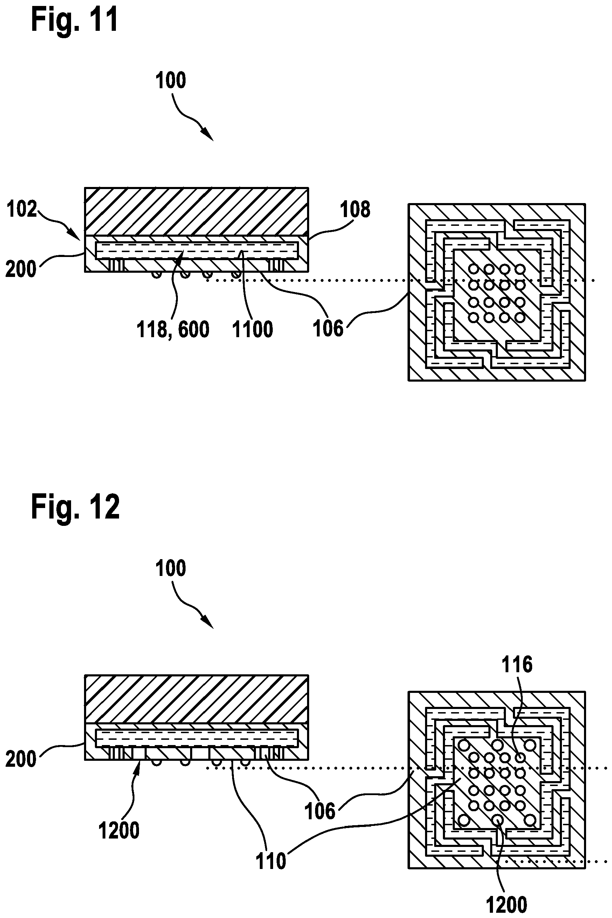

Fig. 11 zeigt eine Darstellung eines Bauelements 100 mit seitlicher Öffnung 1100 des Hohlraums 118 gemäß einem Ausführungsbeispiel der vorliegenden Erfindung. Das Bauelement 100 entspricht dem Bauelement in Fig. 6. Das Bauelement 100 ist in unmontiertem Zustand dargestellt. Wie in Fig. 6 ist der Hohlraum 118 mit dem Kompressionsgel 600 gefüllt. Zusätzlich zu Fig. 6 weist das Bauelement 100 in dem Substratunterbau 102 zumindest eine seitliche Öffnung 1100 auf. Die seitliche Öffnung 1100 ist im Bereich der Zwischenebene 200 angeordnet. Die Zwischenebene 200 verbindet hier die erste Ebene 106 mit der zweiten Ebene 108 zumindest an zwei gegenüberliegenden Seiten des Bauelements 100. An zumindest einer der quer dazu angeordneten Seiten weist die Zwischenlage 200 eine Durchgangsöffnung 1100 auf, an der das Kompressionsgel 600 bei einer Druckbelastung seitlich ausweichen kann.

Fig. 12 zeigt eine Darstellung eines Bauelements 100 mit Öffnungen 1200 in der ersten Ebene 106 gemäß einem Ausführungsbeispiel der vorliegenden Erfindung. Das Bauelement 100 entspricht dem Bauelement in Fig. 11. Im Gegensatz zu Fig. 11 sind die Öffnungen 1200 zum Volumenausgleich als Durchgangsöffnungen 1200 in der ersten Ebene 106 ausgeführt. Die Öffnungen 1200 sind neben den Schnittstellen 116 im ersten Teilbereich 110 angeordnet. Die Zwischenebene 200 ist hier an allen vier Seiten geschlossen ausgeführt.

Bezüglich der Vergelung der Kavität 118 können die unterschiedlichen thermischen Ausdehnungskoeffizienten von Dämpfergelen 600, 700 und Substrat 102 beachtet werden. Dazu können zusätzliche Öffnungen 1200 im Boden der ersten Substratebene 106 oder seitliche Öffnungen 1100 in der zweiten Substratebene 200 sogenannte Arbeitsräume für das Dämpfergel 600 im Bezug auf thermomechanische Verspannungen aber auch zur Anpassung des Dämpfungsvermögens bereitstellen.

In den Figuren 6 bis 12 sind Herstellungsstadien des Bauelementes bzw. eines Teils des Bauelementes während seiner Herstellung dargestellt, wobei die Vorgehensweise wiedergegeben ist, ein Dämpferelastomer 600 während des Herstellungsprozesses beispielsweise durch Embedding einer Silikonmatte oder Siebdrucken eines weichen Materials direkt in den Hohlraum 118 einzubringen.

Mit seitlichen Öffnungen 110 in der mittleren Substratebene 200 kann der Arbeitsraum des Dämpferelastomers 600 erweitert werden, wodurch die Auswirkungen der unterschiedlichen thermischen Ausdehnungskoeffizienten von Substrat 102 und Dämpferelastomer 600 reduziert werden können. Dies ist auch hilfreich, um ggf. mehrere Systeme im Nutzen zu vergelen. Zudem wird durch diese Arbeitsräume der Sensor-Offset durch Lötstress weiter reduziert.

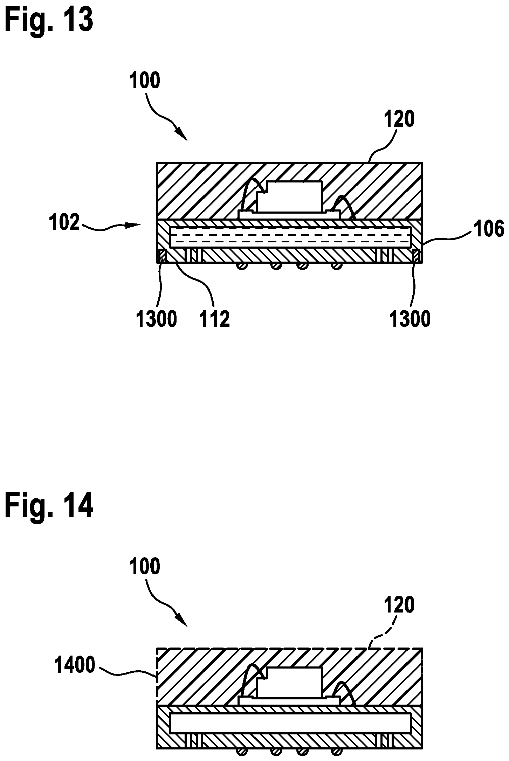

Fig. 13 zeigt eine Schnittdarstellung eines Bauelements 100 mit einem Ausgleichsgewicht 1300 in der ersten Ebene 106 gemäß einem Ausführungsbeispiel der vorliegenden Erfindung. Das Bauelement 100 entspricht dem Bauelement in Fig. 6. Das Bauelement 100 ist in unmontiertem Zustand dargestellt. Zusätzlich weist das Bauelement in dem Substratunterbau 102 ein Ausgleichsgewicht 1300 zum Auswuchten des Bauelements 100 auf. Das Ausgleichsgewicht 1300 ist möglichst weit weg von dem Gehäuse 120 angeordnet und weist einen möglichst großen Abstand zu einem virtuellen Drehpunkt des Bauelements 100 auf. Deshalb ist das Ausgleichsgewicht 1300 in dem zweiten Teilbereich 112 der ersten Ebene 106 angeordnet. Das Ausgleichsgewicht 1300 ist als ringförmig um die erste Ebene 106 umlaufende Masseansammlung 1300 ausgebildet. Das Ausgleichsgewicht 1300 ist hier aus Leiterbahnmaterial, also Kupfer oder Aluminium und weist ein deutlich höheres spezifisches Gewicht auf, als das Substrat und/oder das Gussmaterial des Gehäuses 120. Durch das Ausgleichsgewicht 1300 ist der Schwerpunkt des Bauelements 100 näher am virtuellen Drehpunkt und das Bauelement 100 kann sich bei Schwingungen weniger aufschaukeln. Das Ausgleichsgewicht 1300 kann als Leiterbahn verwendet werden.

Aufgrund des großen Masseanteils auf der oberen Substratebene 108 durch die Moldmasse oder den Deckel liegt der Schwerpunkt des Gesamtsystems 100 relativ hoch, was die Ausbildung von Kipp- und Wankmoden begünstigen kann. Zur Reduzierung dieser Moden kann das Bauelement ausgewuchtet werden. Der Schwerpunkt des Gesamtsystems 100 kann in den Bereich der unteren Substratebene 106 verschoben werden. Dies kann beispielsweise während der Substratherstellung durch das Einbringen eines umlaufenden Metallrings 1300 aus Kupfer oder Aluminium bewirkt werden.

Fig. 14 zeigt eine Schnittdarstellung eines Bauelements 100 mit einem geschirmten Gehäuse 120 gemäß einem Ausführungsbeispiel der vorliegenden Erfindung. Das Bauelement 100 entspricht dem Bauelement in Fig. 2. Zusätzlich ist ein Randbereich des Gehäuses 120 elektrisch leitfähig. Beispielsweise ist eine metallische Schicht 1400 auf dem Gehäuse 120 abgeschieden worden. Ebenso kann das Gussmaterial des Gehäuses 120 im Randbereich mit metallischen Partikeln versehen sein, um elektrisch leitfähig zu werden.

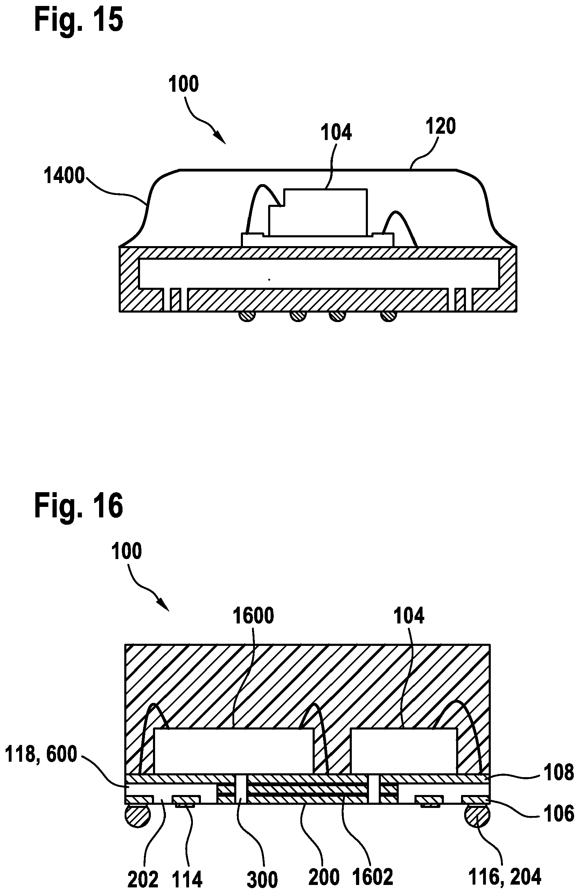

Fig. 15 zeigt eine Schnittdarstellung eines Bauelements 100 mit einem schirmenden Deckel 1500 gemäß einem Ausführungsbeispiel der vorliegenden Erfindung. Das Bauelement 100 entspricht dem Bauelement in Fig. 14. Im Gegensatz dazu ist das Gehäuse 120 als Deckel 1500 ausgebildet. Der Deckel 1500 ist hohl. Der Deckel 1500 ist aus Metall und damit elektrisch leitfähig. Der Deckel 1500 schirmt die elektrische Schaltung 104 vor elektromagnetischen Wellen von außen ab. Ebenso wird die Umgebung von elektromagnetischen Wellen der elektrischen Schaltung 104 abgeschirmt.

Bei der zunehmenden Integration von elektrischen Schaltungen in Autos wird die elektromagnetische Verträglichkeit immer wichtiger. Bei dem hier vorgestellten Bauelement 100 kann der EMV-Schutz durch Aufsprühen einer elektrisch leitenden Schicht 1400 auf die Moldmasse oder durch Verwendung eines Metalldeckels 1500 oder metallisierten Kunststoffdeckels sichergestellt werden.

Fig. 16 zeigt eine Schnittdarstellung eines Bauelements 100 mit einer weiteren elektrischen Schaltung 1600 gemäß einem Ausführungsbeispiel der vorliegenden Erfindung. Das Bauelement 100 entspricht dem Bauelement in Fig. 9. Das Bauelement 100 ist in unmontiertem Zustand dargestellt. Zusätzlich zu der elektrischen Schaltung 104 weist das Bauelement 100 eine weitere elektrische Schaltung 1600 auf. Wie in Fig. 9 ist der Hohlraum 118 und der Durchbruch 202 mit dämpfendem Gel 600 aufgefüllt. Das Gel 600 ist dazu ausgebildet, Schwingungen zwischen der ersten Ebene 106 und der zweiten Ebene 108 zu dämpfen. Hier sind in dem Substratunterbau 102 und den federnden Strukturen 114 Leiterbahnen 1602 und Durchkontaktierungen 300 dargestellt. Die Durchkontaktierungen 300 verlaufen senkrecht zu den Substratebenen in der Insel. Über die Leiterbahnen 1602 und die Durchkontaktierungen 300 sind die elektrischen Schaltungen 104, 1600 mit den Schnittstellen 116 verbunden. An den Schnittstellen sind Lotkugeln 204 angeordnet.

Das Bauelement 100 weist ein vibrationsentkoppelndes Substrat 102 auf. Das Substrat 102 weist eine obere 108 und eine untere Substratebene 106 auf. Die beiden Substratebenen 106, 108 umfassen metallisierte Kontaktflächen 116 und Leiterbahnen 1602 zur elektrischen Kontaktierung von Bauelementen 104, 1600 und weiteren Substratebenen. Die Kontaktflächen der beiden Substratebenen 106, 108 zeigen in entgegengesetzte Raumrichtungen. Weiterhin weist das Bauelement 100 einen mittleren Substratteil 200 auf. Der obere Substratteil 108 erstreckt sich lateral über die Fläche des gehausten Bauelementbereiches. Der obere Substratteil 108 ist Träger der Bauelemente 104, 1600, welche zu diesem kontaktiert werden. Der mittlere Substratteil 200 ist zentrisch angeordnet und verbindet den unteren 106 und den oberen Substratteil 108 miteinander. Umlaufend um den mittleren Substratteil 200 erstreckt sich ein Hohlraum 118, welcher vom oberen 108 und unteren Substratteil 106 in mindestens zwei Raumrichtungen eingegrenzt wird. Der Hohlraum 118 weist umlaufend um das vibrationsentkoppelnde Substrat 102 eine Öffnung auf. Der Hohlraum 118 stellt die Balkenstrukturen 114 des unteren Substratteiles 106 frei. Der mittlere Substratteil 200 weist metallisierte Durchkontakte 300 auf, welche die Kontaktflächen des oberen Substratteils 108 mit den Kontaktflächen 116 des unteren Substratteils 106 elektrisch verbinden.

Durch die Integration der vibrationsentkoppelnden Strukturen/Substrates 102 im ersten Gehäuselevel ergibt sich eine Verringerung der Baugröße sowie eine Material- und Kostenersparnis. Durch die zwischen den Bauelementen 100 und den Lötkontakten 116 an der Substratunterseite ausgeprägten Federbalken 114 wird thermomechanischer und mechanischer Stress, welcher durch die Lötkontaktierung von weiteren Substraten eingebracht wird, entkoppelt. Der Drift und der Offset der Sensorsignale wird deutlich verringert.

Durch das Ausfüllen des Hohlraumes 118 mit einem Dämpfergel 600 und dem damit verbundenen äußeren Verschluss des Hohlraumes 118, sowie die umlaufenden Lotbälle 204 im äußeren Bereich 110 des unteren Substratteils 106 wird ein mechanischer Kurzschluss durch Partikel weitestgehend vermieden.

Die zentrische Anordnung des mittleren Substratteils 200 stabilisiert das System 100 bei Druckbelastung im Substratherstellungs- bzw. Moldprozess, eine weitere Stabilisierung kann durch partielle Stützbereiche im Sägeschnittbereich (lateraler Abschluss des Systems) erreicht werden, welche beim Vereinzelungsprozess ohne zusätzliche Prozessschritte entfernt werden.

Der obere Substratteil 108, dargestellt in der Ausführungsform als PCB-Core, erstreckt sich über die gesamte Fläche des Moldbereichs, zudem dient dieser als Träger der Bauelemente 104, 1600, welche zum oberen Substratteil 106 kontaktiert werden. Die Bauelemente 104, 1600 können durch Kleben, Löten aufgebracht und über Drahtbonds oder Flipchip-Technik mittel Löt- oder Studbumpkontakten zu den Metallisierungsflächen kontaktiert werden. Der untere Substratteil 106, dargestellt als PCB-Core, enthält die balkenähnlichen Federstrukturen 114 sowie weitere Metallisierungsflächen als Leiterbahnen 1602 oder zur Kontaktierung weiterer Substrate über Lotballs 204. Die Kontaktflächen der oberen 108 und der unteren 106 Substratebene zeigen in unterschiedliche Raumrichtungen. Die Leiterbahnen 3602 sind mit Lötstoplack isoliert, die Kontaktflächen 116 sind von Lötstoplack freigestellt. Der mittlere Substratteil 200 (Substratinsel), dargestellt durch einen PCB-Core, ist zentrisch angeordnet und verbindet den oberen Substratteil 108 mit dem unteren Substratteil 106, des Weiteren enthält dieser Durchkontakte 300 zur Verbindung der Metallisierung des oberen Substratteils 108 mit der Metallisierung des unteren Substratteils 106. Die Herstellung des Substrates 102 kann durch vorstrukturierte SubstratCores erfolgen, welche durch Prepregs mechanisch fest verpresst werden. Die Strukturierung kann durch Fräsen, Laser oder andere Strukturierungsverfahren erfolgen. Alternativ können mindestens zwei der Core-Ebenen 106, 108, 200 auch aus einem Core durch "Sackloch"-Strukturierung hergestellt werden. Beispielsweise kann der obere Substratteil 108 und der mittlere Substratteil 200 durch "Sackloch"-Strukturierung hergestellt werden. Umlaufend um den mittleren Substratteil 200 erstreckt sich ein Hohlraum 118, welcher sich bis zur umlaufenden Außenkante des Substrates 102 erstreckt und die Balkenstrukturen 114, welche ebenfalls Leiterbahnen 1602 tragen freistellt. Der Hohlraum 118 kann vor dem Verpressen durch die genannten Strukturierungsverfahren erzeugt und in die Cores eingebracht werden oder während des Verpressens mit einer Opferschicht (z. B. Metall, Polymer) ausgefüllt sein, welche zu einem späteren Zeitpunkt durch thermische, chemische oder physikalische Zersetzung entnommen wird. Zur Dämpfung der Vibrationsbelastungen kann der Hohlraum 118 mit einem Dämpfergel 600 ausgefüllt werden. Das Vergelen kann durch die seitlichen Öffnungen des Hohlraumes 118 sehr einfach in einem Multinutzen, der viele Substratsysteme 100 in einem Nutzen vereint, erfolgen. Alternativ kann das Gel 600 bereits im Herstellungsprozess des Substrates 102 durch Drucktechniken oder Embedding eingebracht werden. Dann kann das Gel 600 als Formgeber der Coreverpressung dienen. Durch den mit Gel 600 bis zum äußeren Abschluss des Systems 100 ausgefüllten Hohlraum 118 in Kombination mit dem einstellbaren Pitch des Lotballs 204 an der Unterseite des unteren Substratteils 106 ("Gitterfunktion") wird ein mechanischer Kurzschluss durch Blockieren der Balkenstrukturen 114 mit Partikeln verhindert. Alternativ zum Molden kann die Einhausung 120 auch durch einen Metall- oder Kunststoffdeckel erfolgen.

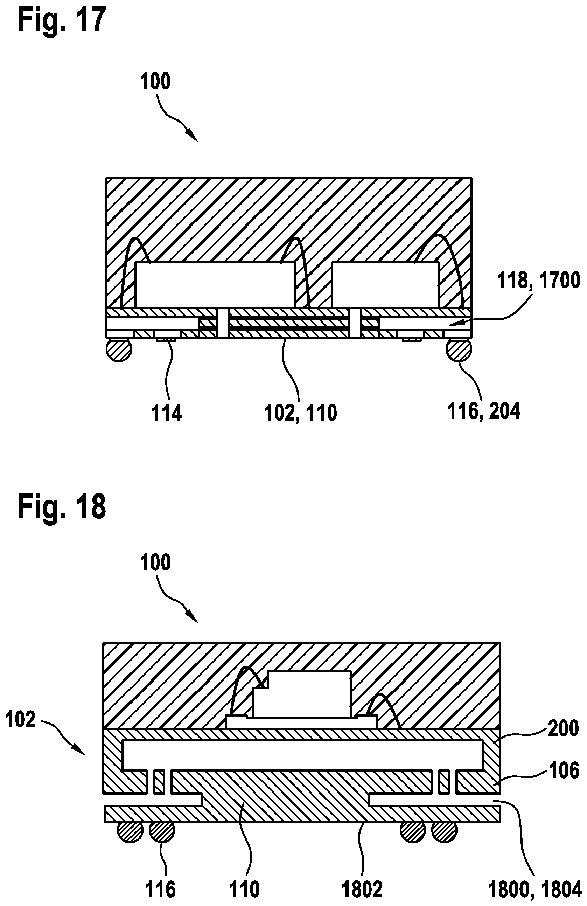

Fig. 17 zeigt eine Schnittdarstellung eines Bauelements 100 mit einem Opfermaterial 1700 zum Herstellen des Hohlraums 118 gemäß einem Ausführungsbeispiel der vorliegenden Erfindung. Das Bauelement 100 entspricht dem Bauelement in Fig. 16. Im Gegensatz zu Fig. 16 ist der Hohlraum 118 nicht mit Gel gefüllt. Der Hohlraum 118 ist mit dem Opfermaterial 1700 gefüllt. Das Opfermaterial 1700 wird entfernt, wenn das Bauelement 100 über die Schnittstellen 116 und die Lotperlen 204 an seinem Bestimmungsort befestigt ist. Durch das Entfernen des Opfermaterials 1700 wird das Bauelement 100 schwingfähig.

In Fig. 17 ist eine Ausführungsform eines Bauelements 100 nach dem hier vorgestellten Ansatz dargestellt. Der sich umlaufend um den mittleren Substratbereich 200 ausdehnende Hohlraum 118 ist mit einer Opferschicht 1700 ausgefüllt. Diese Opferschicht 1700 aus Metall oder Kunststoff kann vor dem Verpressen der Substratcores 102 eingebracht werden und als Formgebung beim Verpressen dienen. Die Entfernung der Opferschicht 1700 kann thermisch, chemisch, nasschemisch oder physikalisch (Plasma) erfolgen. Alternativ kann die Opferschicht 1700 auch durch Presstechnik im Multinutzen in den Hohlraum 118 des verpressten Substrates 102 eingebracht werden. In beiden Verfahrensformen kann die Opferschicht 1700 als Gelstopp für das Vergelen der Strukturierungsbereiche um die balkenähnlichen Strukturen 114, z. B. durch Sieb- oder Schablonendrucktechnik, dienen und anschließend über die umlaufende Öffnung des Hohlraumes 118 entfernt werden. Um Kippbewegungen des Systems 100 durch hohe Massenschwerpunkte und Unwucht zu verhindern, kann der zentrisch eingebrachte mittlere Substratbereich 110 mit zusätzlichen Massen ausgeführt werden, dies kann unter anderem durch Metalllagen wie Kupfer oder Aluminium erfolgen, welche bei der Substratherstellung aufgepresst oder aufgewachsen bzw. abgeschieden werden.

Der umlaufend offene Hohlraum 118 ermöglicht es zudem ausschließlich die Strukturierungsbereiche um die Balkenstrukturen 114 zu vergelen, indem eine Opferschicht 1700, welche den Hohlraum 118 ausfüllt, als Gelstopp dient und nach der Vergelung über die seitlichen Öffnungen entnommen wird.

Die Figuren 1 bis 17 zeigen Ausführungsbeispiele für eine verbesserte Dämpfungsvorrichtung 102 für mikromechanische Sensoren 104 zum Entkoppeln der Sensoranordnung 100 von ungewollten Schwingungen.

Durch die Integration der vibrationsentkoppelnden Dämpfungsanordnung 102 im ersten Gehäuselevel ergibt sich eine Verringerung der Baugröße sowie eine Material- und Kostenersparnis.

Durch die seitlich geöffneten Hohlräume ergibt sich bei der Dämpfungsanordnung 102 die Möglichkeit einer sehr einfachen Vergelung und/oder Füllung mehrerer Dämpfungsanordnungen 102 über das Einspritzen an einem Anspritzpunkt.

Durch die zwischen den Bauelementen 104 und den Lötkontakten 116 an der Dämpfungsanordnungsunterseite ausgeprägten Federbalken 114 wird thermomechanischer und mechanischer Stress entkoppelt, welcher durch die Lötkontaktierung von weiteren Substraten eingebracht wird. Zudem werden Drift und Offset der Sensorsignale deutlich verringert.

Durch das Ausfüllen des Hohlraumes 118 mit einem Dämpfergel 600 und dem damit verbundenen äußeren Verschluss des Hohlraumes 118, sowie die umlaufende Kugelgitteranordnung 116 im äußeren Bereich 110 des unteren Dämpfungsanordnungsteils 106 wird ein mechanischer Kurzschluss durch Partikel weitestgehend vermieden.

Die zentrische Anordnung des mittleren Anordnungselements 200 stabilisiert das System 100 bei Druckbelastung im Moldprozess. Eine weitere Stabilisierung kann durch partielle Stützbereiche im Sägeschnittbereich (lateraler Abschluss des Systems) erreicht werden, welche beim Vereinzelungsprozess ohne zusätzliche Prozessschritte entfernt werden.

Der umlaufend offene Hohlraum 118 ermöglicht es zudem ausschließlich die Strukturierungsbereiche um die Balkenstrukturen 114 zu vergelen und/oder abzudichten und/oder zufüllen, indem eine optionale Opferschicht 1700, welche den Hohlraum 118 ausfüllt, als Gelstopp dient und nach der Vergelung über die seitlichen Öffnungen entnommen wird.

Fig. 18 zeigt eine Schnittdarstellung eines Bauelements 100 mit einem fünfschichtigen Substratunterbau 102 gemäß einem Ausführungsbeispiel der vorliegenden Erfindung. Das Bauelement entspricht dem Bauelement in Fig. 2. Neben der Zwischenebene 200 weist der Schichtunterbau 102 zusätzlich zu Fig. 2 eine vierte Ebene 1800 und eine fünfte Ebene 1802 auf. Die vierte und fünfte Ebene 1800, 1802 sind unterhalb der ersten Ebene 106 angeordnet. Die Schnittstellen 116 sind auf der Unterseite der fünften Ebene 1802 angeordnet. Die Schnittstellen 116 sind über Leiterbahnen und Durchkontaktierungen in der vierten und fünften Ebene 1800, 1802 mit der ersten Ebene 106 verbunden. Zwischen der ersten Ebene 106 und der fünften Ebene 1802 ist ein weiterer Hohlraum 1804 ausgebildet. Der weitere Hohlraum 1804 umschließt die vierte Ebene 1800. Die vierte Ebene 1800 bildet eine Insel in dem weiteren Hohlraum 1804 aus. Die vierte Ebene 1800 ist mit dem ersten Teilbereich 110 der ersten Ebene 106 verbunden. Der weitere Hohlraum 1804 ist über den Durchbruch 202 mit dem ersten Hohlraum 118 verbunden. Der weitere Hohlraum 1804 ermöglicht eine Bewegungsfreiheit für den schwingend gelagerten Teil des Bauelements 100.

Im hier dargestellten Ausführungsbeispiel ist die Federstruktur 114 gegen mechanische Partikel geschützt. Weiterhin ist die elektrische Kontaktierung über einen äußeren Ballring 116 möglich, wodurch das Bauelement pinkompatibel mit dem Footprint von BGAs/LGAs ohne Dämpferstruktur werden kann.

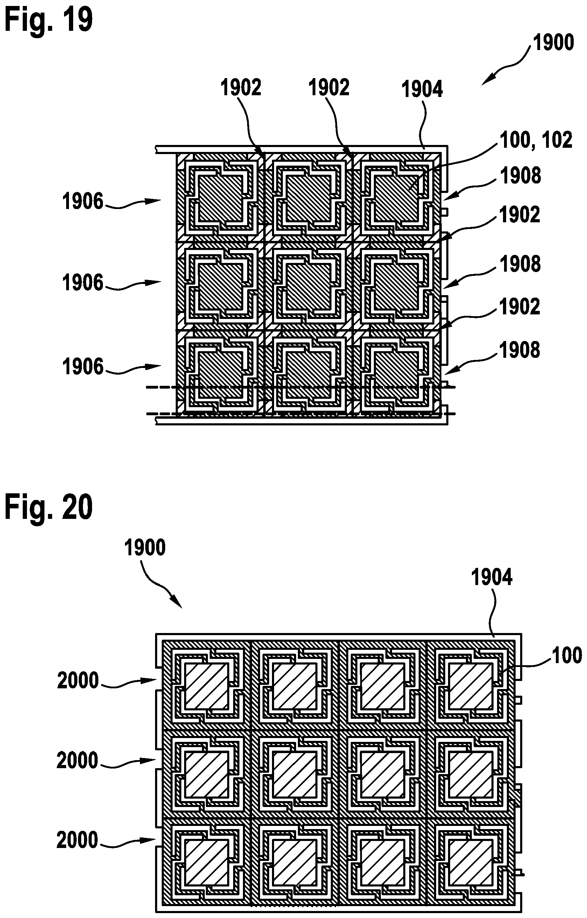

Fig. 19 zeigt eine Darstellung eines Nutzen 1900 gemäß einem Ausführungsbeispiel der vorliegenden Erfindung. In dem Nutzen 1900 sind neun baugleiche Bauelemente 100 gemäß dem hier vorgestellten Ansatz zur Produktion in einem Raster von drei Reihen a drei Bauelementen 100 zusammengefasst. Die Bauelemente 100 sind dicht gepackt. Die Hohlräume der einzelnen Bauelemente 100 sind seitlich miteinander verbunden. Zwischen den Bauelementen 100 sind Sägeschnittlinien 1902 vorgesehen. Insbesondere sind die Ebenen des Substratunterbaus 102 einzeln strukturiert worden und anschließend zu dem Nutzen 1900 verbunden worden. In Fig. 19 sind die Ebenen, wie sie in Fig. 3 dargestellt sind, übereinander angeordnet. Der Nutzen 1900 ist hier vor einer Bestückung und Verdrahtung der elektrischen Schaltungen und vor einem Vergießen mit Gussmasse für die Gehäuse dargestellt. Der Nutzen 1900 ist an drei Seiten durch eine Abdichtung 1904 begrenzt. Die Abdichtung 1904 dichtet die offenen Hohlräume seitlich ab. Eine vierte Seite des Nutzens 1900 ist offen. Durch die freiliegenden Zugänge 1906 zu den Hohlräumen kann das Gel in die Hohlräume eingebracht werden. Um Lufteinschlüsse zu vermeiden, weist die Abdichtung 1904 gegenüber der offenen Seite Entlüftungsöffnungen 1908 auf.

In Fig. 19 ist eine Substrat-Arrayanordnung 1900 bzw. eine Substrat-Array(Nutzen)-Anordnung 1900 dargestellt. Anhand des Nutzens kann das Verfahren zur Herstellung des Substratverbundes 1900 verdeutlicht werden. Die Substrat-Array-Anordnung 1900 verbindet die Hohlräume 118 der im Nutzen 1900 angeordneten Substrate 100 miteinander.

Fig. 20 zeigt eine Darstellung eines Nutzen 1900 gemäß einem weiteren Ausführungsbeispiel der vorliegenden Erfindung. Der Nutzen 1900 entspricht dem Nutzen in Fig. 19. Hier sind zwölf Bauelemente 100 in einem Nutzen zusammengefasst. Die Abdichtung 1094 umschließt hier alle vier Seiten des Nutzens. Die Abdichtung 1904 weist hier Einspritzpunkte 2000 zum Einbringen des Gels auf.

Die Substrate 102 können auch nach der Herstellung der Substrate 102 vergelt werden. Die zusätzlichen Öffnungen 1906, 2000 in der zweiten Substratebene (der Zwischenebene) bieten Vorteile für die Vergelung nach der Herstellung der Substrate 102. Ohne diese Öffnungen müssten die Hohlräume eines jedes Systems für sich vergelt werden, wodurch höhere Kosten entstehen. Durch die Öffnungen 1906, 2000 ist nun aber eine Vergelung im Nutzen 1900 möglich, sodass viele Systeme 100 auf einmal vergelt werden können. Hierfür wird der Nutzen 1900 auf der Unterseite abgedichtet. Dabei werden die Öffnungen aufgrund der Federbalkenstruktur verschlossen. Auf ein Abdichten an der Seite kann durch geschickte Substratgestaltung und am Fließwegende durch eine Überlaufkavität verzichtet werden. Anschließend kann von einer Seite aus mit Druck (bzw. durch Absaugen auf der Entlüftungsseite) das Gel im gesamten Nutzen 1900 schnell und kostengünstig (im Vergleich zum Vergelen von Einzelsystemen) eingebracht werden.

Bestehende Dämpferkonzepte zeichnen sich durch relativ große Abmessungen sowie hohe Kosten aus. Durch das Integrieren des Substratunterbaus 102 unterhalb des Moldgehäuses 120 verringern sich der Materialbedarf und Kosten. Die Vergelung des Systems 100im Bereich um die Federbalken 114 kann als abschließender Prozessschritt durchgeführt werden, da dies nach dem Aufbringen des Moldpackages 120 durchgeführt werden kann. Die Vergelung kann mittels Spritztechnik durchgeführt werden. Das Aufsetzen des Spritzwerkzeuges beidseitig des Substrates auf fragilen Substratstrukturen entfällt. Die Bereiche, an denen das Werkzeug aufgesetzt wird, können entfallen und können für weitere Bauelemente genutzt werden. Ungenutzte Substratfläche kann reduziert werden, wodurch sich eine weitere Baugrößen- und Kostenreduktion ergibt. Alle Systeme 100 eines Nutzens 1900 können in einem Schritt durch einen gemeinsamen Anspritzpunkt vergelt werden. Durch die seitlichen geschlossenen Strukturen 102 wird die Gefahr reduziert, dass Partikel den Dämpfer mechanisch kurzschließen und die Vibrationsentkopplung verhindern. Des Weiteren wird das Sensorgehäuse 120 durch das Dämpfersubstrat 102 von thermomechanischem Stress sowie mechanischer Stress durch die über die Kontakte eingebrachten Verspannungen entkoppelt. Dies hat eine reduzierte Drift bzw. Offset der Sensorsignale zur Folge.

Die Figuren 19 und 20 zeigen eine Anordnung vibrationsentkoppelnder Substrate 100 in einem Multinutzen 1900. Durch die seitliche, umlaufende Öffnung der Hohlräume eines jeden Systems 100 ergibt sich eine Verbindung aller Hohlräume. Es ist dadurch sehr einfach möglich, viele Systeme 100 in einem Arbeitsschritt durch Presstechniken zu vergelen. Dabei umfliest Gel den mittleren Substratteil, also die Substrat-Inseln der Einzelsysteme 100. Eine umlaufende Abdichtung 1904 begrenzt den Gelfluss. Die Abdichtung 1904 kann auch durch ein Werkzeug oder durch eine Integration im Substratnutzen 1900, welche durch Vereinzelung nach Aushärtung des Gels entfernt wird, erfolgen. Zur Verhinderung von Einschlüssen kann die Abdichtung 1904 mit Entlüftungsöffnungen 1908 versehen werden. Die Aufbautechnik und Kontaktierung der Bauelemente und das Molden können ebenfalls im Nutzen 1900 erfolgen. Zur Stabilisierung der Systeme 100 unter Druckbelastung beim Molden oder Verpressen der Einzelcores können zusätzliche Stützstellen in den Sägeschnittbereichen 1902 enthalten sein, welche durch den Sägeschnitt entfernt werden. Die Vereinzelung der Systeme 100 erfolgt als abschließender Prozessschritt nach dem Molden oder Deckeln der Systeme 100.

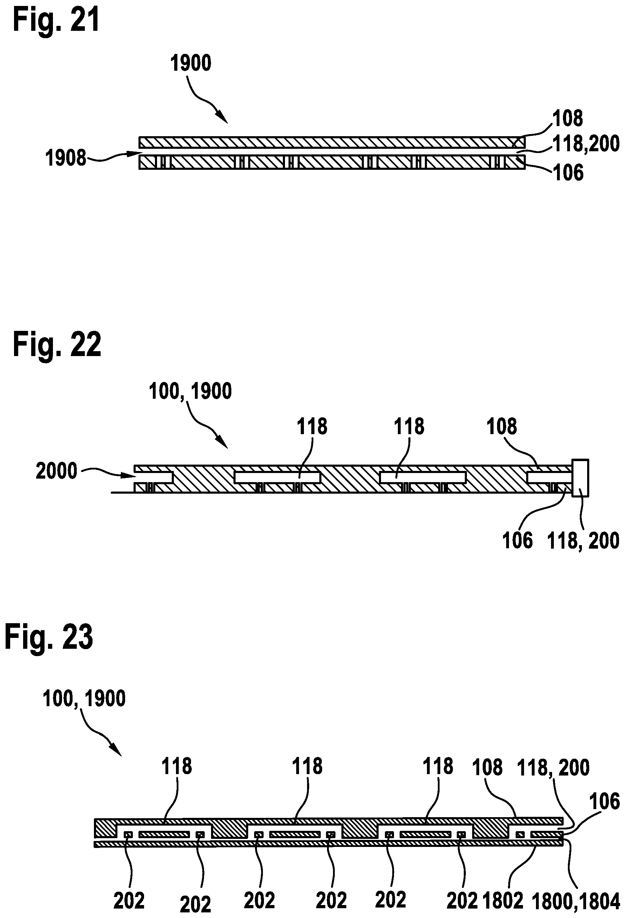

Fig. 21 zeigt eine Schnittdarstellung eines Nutzen 1900 gemäß einem Ausführungsbeispiel der vorliegenden Erfindung. Der Nutzen 1900 entspricht dem Nutzen in Fig. 19. Der Nutzen 1900 ist aus der ersten Ebene 106, der Zwischenebene 200 und der zweiten Ebene 108 zusammengesetzt. In Fig. 21 schneidet die Schnittebene der Schnittdarstellung im Bereich der Zwischenebene 200 nur den Hohlraum 118. Der Hohlraum 118 ist durchgehend, sodass von dem Zugang 1908 der Hohlraum 118 vollständig mit Dämpfungsgel gefüllt werden kann.

Fig. 22 zeigt eine Schnittdarstellung eines Nutzen 1900 gemäß einem weiteren Ausführungsbeispiel der vorliegenden Erfindung. Der Nutzen 1900 entspricht dem Nutzen in Fig. 19 oder Fig. 20. Die Schnittebene schneidet die Bauelemente 100 im Bereich der Insel, wo die erste Ebene 106, die Zwischenebene 200 und die zweite Ebene 108 zusammenhängen. Deshalb ist der Hohlraum 118 hier unterbrochen dargestellt. Tatsächlich sind die Hohlräume 118 jedoch außerhalb der Schnittebene zusammenhängend, sodass der zusammenhängende Hohlraum 118 von dem Einspritzpunkt 2000 her mit Gel gefüllt werden kann.

Fig. 23 zeigt eine Schnittdarstellung eines fünfschichtigen Nutzen 1900 gemäß einem Ausführungsbeispiel der vorliegenden Erfindung. In dem Nutzen 1900 sind Bauelemente 100 zusammengefasst, wie sie in Fig. 18 dargestellt sind. Hier weist der Nutzen 1900 fünf Schichten 106, 108, 200, 1800, 1802 auf. Wie in Fig. 21 schneidet die Schnittebene im Bereich der vierten Ebene 1800 nur den weiteren Hohlraum 1804. Ansonsten ist deutlich erkennbar, dass alle Hohlräume 118 auch über den weiteren Hohlraum 1804 und durch die Durchbrüche 202 mit dem Gel gefüllt werden können, da die Hohlräume 118 und der weitere Hohlraum 1804 zusammenhängen. Dadurch kann der Hohlraum 118 eines Bauelements 100 vor Verschmutzungen geschützt werden.

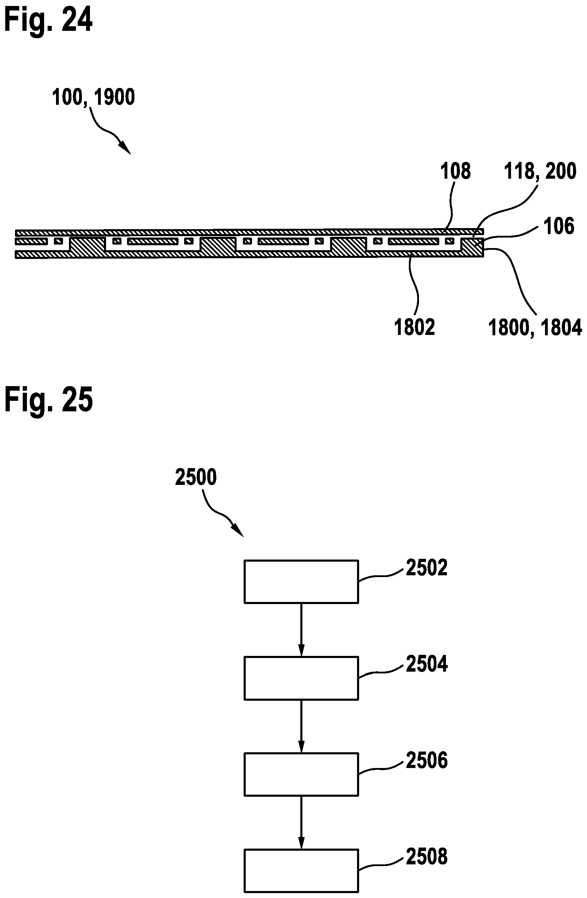

Fig. 24 zeigt eine Schnittdarstellung eines fünfschichtigen Nutzen 1900 gemäß einem weiteren Ausführungsbeispiel der vorliegenden Erfindung. Der Nutzen weist wie in Fig. 23 fünf Schichten auf. Hier sind die Hohlräume 118 zumindest an zwei gegenüberliegenden Seiten zusammenhängend ausgeführt. Die erste Ebene 106 ist außerhalb der Schnittebene mit der zweiten Ebene verbunden. Dadurch kann der weitere Hohlraum 1804 unterbrochen ausgeführt sein. Die Hohlräume 118 und die weiteren Hohlräume 1804 können durch den zusammenhängenden Hohlraum 118 gefüllt werden. Bei dieser Ausführungsvariante sind nach dem Vereinzeln der Bauelemente 100 der Hohlraum 118 und der weitere Hohlraum 1804 zur Umgebung offen.

Durch die seitlich geöffneten Hohlräume 118 ergibt sich bei Anordnung des Substrates 102 die Möglichkeit einer sehr einfachen Vergelung mehrerer Systeme im Nutzen 1900, auf eine Spritztechnik mit Anspritzpunkten für wenige Systeme bzw. aufsetzende Spritzwerkzeuge kann verzichtet werden und Gelflash sowie ungenutzte Substratflächen werden verhindert.

Fig. 25 zeigt ein Ablaufdiagramm eines Verfahrens 2500 zum Herstellen eines Bauelements gemäß einem Ausführungsbeispiel der vorliegenden Erfindung. Das Verfahren 2500 weist einen Schritt 2502 des Bereitstellens, einen Schritt 2504 des Anordnens, einen Schritt 2506 des Einbringens und einen Schritt 2508 des Trennens auf. Im Schritt 2502 des Bereitstellens wird ein Nutzen, wie er beispielsweise in einer der Figuren 19 bis 24 dargestellt ist bereitgestellt. Die Hohlräume der Bauelemente sind untereinander verbunden. Im Schritt 2504 des Anordnens wird der Nutzen in einer Form angeordnet, die um den Nutzen umlaufend anliegt und den Nutzen an einer Auflagefläche abdichtet, um die Hohlräume abzudichten. Die Form weist zumindest einen Einspritzpunkt als Zugang zu den Hohlräumen auf. Im Schritt 2506 des Einbringens wird ein Gel in die Hohlräume durch den Einspritzpunkt eingebracht, um das Kompressionsgel in die Hohlräume und alternativ oder ergänzend das Schergel in die federnden Strukturen einzubringen. Im Schritt 2508 des Trennens wird der Nutzen entlang der Sägegassen getrennt, um die Bauelemente zu vereinzeln.

Die beschriebenen und in den Figuren gezeigten Ausführungsbeispiele sind nur beispielhaft gewählt. Unterschiedliche Ausführungsbeispiele können vollständig oder in Bezug auf einzelne Merkmale miteinander kombiniert werden. Auch kann ein Ausführungsbeispiel durch Merkmale eines weiteren Ausführungsbeispiels ergänzt werden.

Ferner können erfindungsgemäße Verfahrensschritte wiederholt sowie in einer anderen als in der beschriebenen Reihenfolge ausgeführt werden.

Umfasst ein Ausführungsbeispiel eine "und/oder"-Verknüpfung zwischen einem ersten Merkmal und einem zweiten Merkmal, so ist dies so zu lesen, dass das Ausführungsbeispiel gemäß einer Ausführungsform sowohl das erste Merkmal als auch das zweite Merkmal und gemäß einer weiteren Ausführungsform entweder nur das erste Merkmal oder nur das zweite Merkmal aufweist.

## Patentansprüche

1. Bauelement (100) mit folgenden Merkmalen:
einem Substrataufbau (102) aus einer ersten Ebene (106) aus einem Substrat und einer zweiten Ebene (108) aus dem Substrat, wobei die erste Ebene (106) einen relativ zu der zweiten Ebene (108) beweglich gelagerten ersten Teilbereich (110) und einen mechanisch und elektrisch mit der zweiten Ebene (108) verbundenen zweiten Teilbereich (112) aufweist, wobei zwischen dem ersten Teilbereich (110) und dem zweiten Teilbereich (112) federnde Strukturen (114) aus der ersten Ebene (106) ausgebildet sind und der erste Teilbereich (110) Schnittstellen (116) zum elektrischen und mechanischen Verbinden mit einer Leiterplatte (602) aufweist und zwischen der ersten Ebene (106) und der zweiten Ebene (108) ein Hohlraum (118) zum Ermöglichen einer Relativbewegung zwischen den Schnittstellen (116) und der zweiten Ebene (108) angeordnet ist; und
einer elektrischen Schaltung (104), die auf der zweiten Ebene (108) innerhalb eines Gehäuses (120) angeordnet ist, wobei die Schaltung (104) über den Substrataufbau (102) elektrisch mit den Schnittstellen (116) verbunden ist.

2. Bauelement (100) gemäß Anspruch 1, bei dem der Hohlraum (118) des Substrataufbaus (102) zumindest teilweise mit einem Kompressionsgel (600) zwischen dem ersten Teilbereich (110) der ersten Ebene (106) und der zweiten Ebene (108) gefüllt ist und/oder in einem Bereich der federnden Strukturen (114) ein Schergel (700) zwischen dem ersten Teilbereich (110) der ersten Ebene (106) und dem zweiten Teilbereich (112) der ersten Ebene (106) angeordnet ist.

3. Bauelement (100) gemäß einem der vorangegangenen Ansprüche, bei dem der Substrataufbau (102) eine Zwischenebene (200) aufweist, die den zweiten Teilbereich (112) der ersten Ebene (106) mit der zweiten Ebene (108) verbindet, wobei die Zwischenebene (200) eine Höhe des Hohlraums (118) definiert und der zweite Teilbereich (112) als eine, von dem ersten Teilbereich (110) umschlossene Insel oder als ein, den ersten Teilbereich (110) umschließender Rand ausgebildet ist.

4. Bauelement (100) gemäß einem der vorangegangenen Ansprüche 1 bis 4, bei dem der Substrataufbau (102) ein Ausgleichsgewicht (1300) aufweist, wobei das Ausgleichsgewicht (1300) zumindest teilweise in der Zwischenebene (200) liegt, insbesondere wobei ein Schwerpunkt des Ausgleichsgewichtes nicht höher liegt, als ein Schwerpunkt des Bauelementes (100).

5. Bauelement (100) gemäß einem der vorangegangenen Ansprüche, bei dem der Hohlraum (118) des Substrataufbaus (102) zumindest an einer Stelle mit einer Umgebung verbunden ist.

6. Bauelement (100) gemäß einem der vorangegangenen Ansprüche, bei dem der Substrataufbau (102) ein Ausgleichsgewicht (1300) aufweist, wobei das Ausgleichsgewicht (1300) in dem zweiten Teilbereich (112) der ersten Ebene (106) angeordnet ist.

7. Bauelement (100) gemäß einem der vorangegangenen Ansprüche, bei dem das Gehäuse (120) einen elektrisch leitfähigen Schirm (1400) aufweist, der dazu ausgebildet ist, die elektrische Schaltung (104) vor elektromagnetischen Störungen abzuschirmen.

8. Bauelement (100) gemäß einem der vorangegangenen Ansprüche, bei dem die elektrische Schaltung (104) zumindest einen mikroelektromechanischen Sensor (104) umfasst.

9. Nutzen (1900) mit folgendem Merkmal:
einer Mehrzahl von baugleichen Bauelementen (100) gemäß einem der Ansprüche 1 bis 7, wobei die Bauelemente (100) in einem zeilenförmigen und/oder reihenförmigen Raster angeordnet sind, wobei die Ebenen (106, 108, 200) der Substrataufbauten (102) und/oder die Gehäuse (120) als durchgehende Schichten ausgebildet sind, wobei zwischen den Bauelementen (100) Sägegassen (1902) zum Vereinzeln der Bauelemente (100) vorgesehen sind.

10. Nutzen (1900) gemäß Anspruch 9, bei dem die Hohlräume (118) der Bauelemente (100) miteinander verbunden sind.

11. Verfahren (2500) zum Herstellen eines Bauelements (100) gemäß einem der Ansprüche 2 bis 8, wobei das Verfahren (2500) die folgenden Schritte aufweist:
Bereitstellen (2502) eines Nutzen (1900) gemäß Anspruch 9 oder 10;
Anordnen (2504) des Nutzens (1900) in einer Form, die um den Nutzen (1900) umlaufend anliegt und den Nutzen (1900) an einer Auflagefläche abdichtet, um die Hohlräume (118) abzudichten, wobei die Form zumindest einen Einspritzpunkt (200) als Zugang zu den Hohlräumen (118) aufweist;
Einbringen (2506) eines Gels (600, 700) in die Hohlräume (118) durch den Einspritzpunkt (200), um das Kompressionsgel (600) in die Hohlräume (118) und/oder das Schergel (700) in die federnden Strukturen (114) einzubringen; und
Trennen (2508) des Nutzens (1900) entlang der Sägegassen (1902), um die Bauelemente (100) zu vereinzeln.

## Claims

1. Component (100) having the following features:
a substrate structure (102) made of a first plane (106) of a substrate and a second plane (108) of the substrate, wherein the first plane (106) has a first subarea (110) mounted such that it can move relative to the second plane (108), and a second subarea (112) connected mechanically and electrically to the second plane (108), wherein resilient structures (114) are formed from the first plane (106), between the first subarea (110) and the second subarea (112), and the first subarea (110) has interfaces (116) for electrical and mechanical connection to a printed circuit board (602), and a cavity (118) is arranged between the first plane (106) and the second plane (108) in order to permit a relative movement between the interfaces (116) and the second plane (108); and
an electric circuit (104), which is arranged on the second plane (108), within a housing (120), wherein the circuit (104) is connected electrically to the interfaces (116) via the substrate structure (102).

2. Component (100) according to Claim 1, in which the cavity (118) in the substrate structure (102) is at least partly filled with a compression gel (600) between the first subarea (110) of the first plane (106) and the second plane (108), and/or, in an area of the resilient structures (114), a shear gel (700) is arranged between the first subarea (110) of the first plane (106) and the second subarea (112) of the first plane (106).

3. Component (100) according to one of the preceding claims, in which the substrate structure (102) has an intermediate plane (200), which connects the second subarea (112) of the first plane (106) to the second plane (108), wherein the intermediate plane (200) defines a height of the cavity (118) and the second subarea (112) is formed as an island enclosed by the first subarea (110) or as an edge enclosing the first subarea (110).

4. Component (100) according to one of the preceding Claims 1 to 4, in which the substrate structure (102) has a compensating weight (1300), wherein the compensating weight (1300) is at least partly located in the intermediate plane (200), in particular wherein a centre of gravity of the compensating weight is not located higher than a centre of gravity of the component (100).

5. Component (100) according to one of the preceding claims, in which the cavity (118) of the substrate structure (102) is connected to the surroundings, at least at one point.

6. Component (100) according to one of the preceding claims, in which the substrate structure (102) has a compensating weight (1300), wherein the compensating weight (1300) is arranged in the second subarea (112) of the first plane (106).

7. Component (100) according to one of the preceding claims, in which the housing (120) has an electrically conductive shield (1400), which is formed so as to shield the electric circuit (104) against electromagnetic interference.

8. Component (100) according to one of the preceding claims, in which the electric circuit (104) comprises at least one micro-electromechanical sensor (104).

9. Blank (1900) having the following feature:
a plurality of identical components (100) according to one of Claims 1 to 7, wherein the components (100) are arranged in a line by line and/or row by row grid, wherein the planes (106, 108, 200) of the substrate structures (102) and/or the housings (120) are formed as continuous layers, wherein sawing lanes (1902) for separating the components (100) are provided between the components (100).

10. Blank (1900) according to Claim 9, in which the cavities (118) of the components (100) are connected to one another.

11. Method (2500) for manufacturing a component (100) according to one of Claims 2 to 8, wherein the method (2500) has the following steps:
providing (2502) a blank (1900) according to Claim 9 or 10,
arranging (2504) the blank (1900) in a mould, which rests circumferentially around the blank (1900) and seals off the blank (1900) on a contact surface in order to seal off the cavities (118), wherein the mould has at least one injection point (200) as an access to the cavities (118),
introducing (2506) a gel (600, 700) into the cavities (118) through the injection point (200) in order to introduce the compression gel (600) into the cavities (118) and/or to introduce the shear gel (700) into the resilient structures (114), and
dividing (2508) the blank (1900) along the sawing lanes (1902) in order to separate the components (100).

## Revendications

1. Composant (100) présentant les caractéristiques suivantes :
une structure de substrat (102) constituée d'un premier plan (106) formé d'un premier substrat et d'un deuxième plan (108) formé du même substrat, le premier plan (106) présentant une première partie (110) montée à déplacement par rapport au deuxième plan (108) et une deuxième partie (112) reliée mécaniquement et électriquement au deuxième plan (108),
des structures élastiques (114) formées du premier plan (106) entre la première partie (110) et la deuxième partie (112), la première partie (110) présentant des interfaces (116) assurant une liaison électrique et mécanique avec une carte de circuit (602),
une cavité (118) qui permet un déplacement relatif entre les interfaces (116) et le deuxième plan (108), disposée entre le premier plan (106) et le deuxième plan (108), et
un circuit électrique (104) disposé sur le deuxième plan (108) à l'intérieur d'un boîtier (120), le circuit (104) étant relié électriquement aux interfaces (116) par l'intermédiaire de la structure de substrat (102).

2. Composant (100) selon la revendication 1, dans lequel la cavité (118) de la structure de substrat (102) est remplie au moins en partie d'un gel de compression (600) prévu entre la première partie (110) du premier plan (106) et le deuxième plan (108) et/ou un gel de cisaillement (700) est disposé dans une partie des structures élastiques (114) entre la première partie (110) du premier plan (106) et la deuxième partie (112) du premier plan (106).

3. Composant (100) selon l'une des revendications précédentes, dans lequel la structure de substrat (102) présente un plan intermédiaire (200) qui relie la deuxième partie (112) du premier plan (106) au deuxième plan (108), le plan intermédiaire (200) définissant la hauteur de la cavité (118) et la deuxième partie (112) étant configurée comme bordure entourant la première partie (110) ou comme îlot entouré par la première partie (110).

4. Composant (100) selon l'une des revendications 1 à 4 qui précèdent, dans lequel la structure de substrat (102) présente un point d'équilibrage (1300), le point d'équilibrage (1300) étant situé au moins en partie dans le plan intermédiaire (200), le centre de masse du point d'équilibrage n'étant pas situé plus haut que le centre de masse du composant (100).

5. Composant (100) selon l'une des revendications précédentes, dans lequel la cavité (118) de la structure de substrat (102) est reliée à l'environnement en au moins un emplacement.

6. Composant (100) selon l'une des revendications précédentes, dans lequel la structure de substrat (102) présente un point d'équilibrage (1300), le point d'équilibrage (1300) étant disposé dans la deuxième partie (112) du premier plan (106).

7. Composant (100) selon l'une des revendications précédentes, dans lequel le boîtier (120) présente un écran (1400) électriquement conducteur configuré pour blinder le circuit électrique (104) vis-à-vis des parasites électromagnétiques.

8. Composant (100) selon l'une des revendications précédentes, dans lequel le circuit électrique (104) comporte au moins un capteur microélectromécanique (104).

9. Ensemble (1900) présentant les caractéristiques suivantes :
plusieurs composants (100) de structure identique, selon l'une des revendications 1 à 7, les composants (100) étant disposés en trame de lignes et/ou de colonnes, les plans (106, 108, 200) des structure de substrat (102) et/ou les boîtiers (120) étant configurés en couches continues, des voies de sciage (1902) permettant de découper un des composants (100) étant prévues entre les composants (100).

10. Ensemble (1900) selon la revendication 9, dans lequel les cavités (118) des composants (100) sont reliées les unes aux autres.

11. Procédé (2500) de fabrication d'un composant (100) selon l'une des revendications 2 à 8, le procédé (2500) présentant les étapes suivantes :
préparer (2502) un ensemble (1900) selon les revendications 9 ou 10,
placer (2504) l'ensemble (1900) dans un moule qui entoure l'ensemble (1900) et qui assure la liaison étanche de l'ensemble (1900) à une surface de placement pour assurer l'étanchéité des cavités (118), le moule présentant au moins un point d'injection (200) donnant d'accès aux cavités (118),
placer (2506) un gel (600, 700) dans les cavités (118) par l'intermédiaire du point d'injection (200) pour placer le gel de compression (600) dans les cavités (118) et/ou le gel de cisaillement (700) dans les structures élastiques (114) et
découper (2508) l'ensemble (1900) le long des voies de sciage (1902) pour séparer les uns des autres les composants (100).
